(19) Europäisches Patentamt

European Patent Office

Office européen des brevets

(11) **EP 4 629 441 A1**

(12) **EUROPEAN PATENT APPLICATION**
published in accordance with Art. 153(4) EPC

(43) Date of publication:
08.10.2025  Bulletin 2025/41

(21) Application number: 23898395.1

(22) Date of filing: 01.12.2023

(51) International Patent Classification (IPC):
*H01Q 9/04* (2006.01)     *H05K 1/02* (2006.01)
*H05K 1/03* (2006.01)

(52) Cooperative Patent Classification (CPC):
H01Q 1/38; H01Q 9/04; H05K 1/02; H05K 1/03

(86) International application number:
PCT/KR2023/019712

(87) International publication number:
WO 2024/117872 (06.06.2024 Gazette 2024/23)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 01.12.2022  KR 20220165450

(71) Applicant: IUCF-HYU (Industry-University
Cooperation
Foundation Hanyang University)
Seoul 04763 (KR)

(72) Inventors:
• JUNG, Yei Hwan
  Seoul 04426 (KR)
• KIM, Sun Hong
  Seoul 05790 (KR)
• YOO, Hyoung Suk
  Suwon-si Gyeonggi-do 16505 (KR)

(74) Representative: Dr. Gassner & Partner mbB
Wetterkreuz 3
91058 Erlangen (DE)

(54) **ANTENNA, METHOD FOR MANUFACTURING SAME, AND FLEXIBLE SYSTEM COMPRISING SAME**

(57)     Provided is an antenna comprising: a composite substrate having elasticity and dielectric properties; a ground panel formed on the lower surface of the composite substrate and grounded; and a patch formed on the upper surface of the composite substrate and resonating at a frequency in a reference range, wherein when the composite substrate and the patch stretch, the dielectric constant of the composite substrate changes, and the frequency of the patch is maintained within the reference range.

【Fig. 1】

## Description

[Technical Field]

The present invention relates to an antenna, a method for manufacturing the same, and a flexible system including the same, and more specifically, to an antenna having elasticity and dielectric properties, in which a frequency is substantially maintained within a reference range when the antenna is stretched in an elongation direction, a method for manufacturing the same, and a flexible system including the same.

[Background Art]

Conventionally, metal materials have been used in a method for manufacturing a dielectric. For example, Korean Unexamined Patent Publication No. 10-2010-0011023 discloses a method for forming a high-k dielectric film, in which a high-k dielectric film formed of a metal oxide is formed by repeating, one or more times, a cycle including a step of introducing a metal precursor into a reaction chamber to form an adsorption layer of the metal precursor on a substrate, a step of purging the metal precursor remaining in the reaction chamber, a step of generating oxygen plasma in a showerhead inside the reaction chamber to react the oxygen plasma with the adsorption layer of the metal precursor, and a step of purging a gas and reaction by-products remaining in the reaction chamber.

Meanwhile, the metal material-based dielectric as described above is required to be stretchable in order to be applied to recent flexible systems. The flexible system herein may mean a system having elasticity, and may include wearable devices, for example.

However, as described above, when the dielectric is based only on the metal material, it is obvious that it is difficult to have elasticity.

Accordingly, conventionally, a dielectric including a material having elasticity, for example, a polymer elastomer, together with the metal material as described above, has been developed. For example, Korean Unexamined Patent Publication No. 10-2017-0017612 discloses a polymer dielectric composition including a conductive filler in a polymer elastomer, in which the conductive filler includes a dispersant represented by the following Chemical Formula 1:

<Chemical Formula 1>　　　　　$CX_3(CX_2)n\text{-}Y$

(where X is H or F, Y is H, $NH_2$, OH, COOH, or $SiR_1R_2R_3$, n is an integer of 1 to 30, and $R_1$, $R_2$, and $R_3$ are the same as or different from each other, and are H, F, Cl, Br, an alkyl group having 1 to 10 carbon atoms, an alkoxy group having 1 to 10 carbon atoms, an alkenyl group having 1 to 10 carbon atoms, an alkyne group having 1 to 10 carbon atoms, an aryl group having 1 to 30 carbon atoms, a cycloalkyl group having 1 to 30 carbon atoms, or a cycloalkenyl group having 1 to 30 carbon atoms).

However, when the existing stretchable dielectric material is stretched, the dielectric constant may change irregularly.

Since the existing stretchable dielectric is irregularly changed in dielectric constant as described above, it may be difficult to apply the conventional stretchable dielectric to flexible systems as a substrate.

This may be because the frequency needs to be maintained within a reference range in a high-frequency device of the flexible systems, for example, an antenna.

However, as described above, since the dielectric constant is irregularly changed when the existing stretchable dielectric is stretched, in a case where the stretchable dielectric is manufactured as an antenna, when the manufactured antenna is stretched, the frequency may not be maintained within the reference range and may be changed. For example, when the existing stretchable dielectric is used as a substrate of an antenna, the frequency of the antenna may be lowered when the stretchable dielectric is stretched in a direction in which the substrate is stretched.

Accordingly, in the case of an antenna manufactured using the existing stretchable dielectric as a substrate, the dielectric constant may be formed while having elasticity, but when the antenna is stretched as described above, the frequency is changed, so that it may be difficult to operate at a specific frequency.

Therefore, there is a need for an antenna capable of substantially maintaining a frequency even when the antenna is stretched.

[Disclosure]

[Technical Problem]

A technical problem to be solved by the present invention is to provide an antenna in which a frequency is substantially maintained within a reference range even when the antenna is stretched, a method for manufacturing the same, and a flexible system including the same.

Another technical problem to be solved by the present invention is to provide an antenna having an excellent thermal conductivity, a method for manufacturing the same, and a flexible system including the same.

Still another technical problem to be solved by the present invention is to provide an antenna that may be applied to a flexible system, a method for manufacturing the same, and a flexible system including the same.

The technical problems to be solved by the present invention are not limited to those described above.

[Technical Solution]

To solve the technical problems, the present invention provides an antenna.

According to one embodiment, the antenna may include: a composite substrate having elasticity and dielectric properties; a ground panel formed on a lower surface of the composite substrate and grounded; and a patch formed on an upper surface of the composite substrate and resonating at a frequency in a reference range, in which when the composite substrate and the patch are stretched, a dielectric constant of the composite substrate may be varied, and a frequency of the patch may be maintained within the reference range.

According to one embodiment, at least one of the ground panel and the patch may be formed of a metal conductor material having elasticity, and the metal conductor material having elasticity may include silver, copper, gold, or aluminum.

According to one embodiment, when the composite substrate and the patch are stretched, the dielectric constant may be varied by a square of a stretched length, and the frequency may be maintained within the reference range.

According to one embodiment, the composite substrate may include a dielectric cluster formed of dielectric powder and having a predetermined shape, when the antenna is stretched in a direction in which the composite substrate is stretched, the predetermined shape of the dielectric cluster may be changed such that a number of the dielectric powder per unit volume of the composite substrate decreases, and the dielectric constant of the composite substrate may decrease linearly.

According to one embodiment, the composite substrate may have a variable dielectric constant range in a stretch range of 0.1% to 30%, and the variable dielectric range may be 1.5 to 7.5.

According to one embodiment, the frequency of the patch may be maintained within the reference range in a stretch range of 0.1% to 30%.

According to one embodiment, the composite substrate may have a thermal conductivity of 0.1 W/mk or greater to 10 W/mk or less.

According to one embodiment, the composite substrate may include a stretchable polymer matrix formed of a stretchable polymer having elasticity, the stretchable polymer may be a silicon-based material, and the silicon-based material may include at least one selected from materials including ecoflex, polydimethylsiloxane (PDMS), and styrene-ethylenebutylene-styrene (SEBS).

According to one embodiment, the dielectric powder may be a metal oxide-based material, and the dielectric powder may be at least one selected from metal oxide-based materials including barium titanate, strontium titanate, and aluminum oxide.

To solve the technical problems, the present invention provides a method for manufacturing an antenna.

According to one embodiment, the method for manufacturing an antenna may include: preparing a composite substrate having elasticity and dielectric properties; forming a ground panel on a lower surface of the composite substrate for grounding; and forming a patch, which resonates at a frequency in a reference range, on an upper surface of the composite substrate, in which when the composite substrate and the patch are stretched, a dielectric constant of the composite substrate may be varied, and a frequency of the patch may be maintained within the reference range.

According to one embodiment, in the forming of the ground panel and in the forming of the patch, at least one of the ground panel and the patch may be formed of a metal conductor material having elasticity, the metal conductor material having elasticity may include silver, copper, gold, or aluminum, the forming of the ground panel may include forming the ground panel by providing the lower surface of the composite substrate with an ink including the metal conductor material having elasticity, and the forming of the patch may include forming the metal conductor material having elasticity on the upper surface of the composite substrate in a pattern having a predetermined shape.

According to one embodiment, the preparing of the composite substrate may include: dispersing a stretchable polymer having elasticity in a solvent to prepare a source solution; mixing dielectric powder having dielectric properties with the source solution to prepare a dielectric source; providing the dielectric powder with a catalyst that causes an attractive force between dielectric powders so as to form a dielectric cluster from the dielectric powders; and curing the dielectric source in which the dielectric cluster is formed to manufacture the composite substrate in which the dielectric cluster is dispersed in a stretchable polymer matrix formed of the stretchable polymer, and in the forming of the dielectric cluster, the catalyst may be provided to the dielectric source by a dripping method, and the catalyst may be water.

To solve the technical problems, the present invention provides an antenna.

According to one embodiment, the antenna may resonate at a frequency in a reference range, when the antenna is stretched, a dielectric constant may be varied by a square of a stretched length, and the frequency may be maintained within the reference range.

To solve the technical problems, the present invention provides a flexible system including the antenna.

According to the embodiment of the present invention, it is possible to provide an antenna including: a composite substrate having elasticity and dielectric properties; a ground panel formed on a lower surface of the composite substrate and grounded; and a patch formed on an upper surface of the composite substrate and resonating at a frequency in a reference range, in which when the composite substrate and the patch are stretched, a dielectric constant of the composite substrate may be varied, and a frequency of the patch may be maintained within the reference range.

Meanwhile, according to the embodiment of the present invention, the composite substrate may include a dielectric cluster formed of dielectric powder and having a predetermined shape, when the antenna is stretched in a direction in which the composite substrate is stretched, the predetermined shape of the dielectric cluster may be changed such that a number of the dielectric powder per unit volume of the composite substrate decreases, and the dielectric constant of the composite substrate may substantially decrease linearly and rapidly.

[Advantageous Effects]

Accordingly, according to the present invention, since the antenna including the composite substrate may substantially maintain a constant frequency, frequency characteristics thereof may be excellent.

Meanwhile, according to the embodiment of the present invention, since the composite substrate includes the dielectric powder, a thermal conductivity thereof may be excellent.

Accordingly, according to the present invention, when the antenna is applied to the flexible system, thermal conductivity characteristics thereof may be excellent.

[Description of Drawings]

FIG. 1 is a view for explaining an antenna according to an embodiment of the present invention.

FIGS. 2 to 10 are views for explaining a method for manufacturing an antenna according to the embodiment of the present invention.

FIGS. 11 to 66 are views for explaining experimental examples of the present invention.

[Mode for Invention]

Hereinafter, preferred embodiments of the present invention will be described in detail with reference to the accompanying drawings. However, the present invention may be embodied in different forms and should not be construed as limited to the embodiments set forth herein. Rather, the embodiments introduced herein are provided so that the disclosed contents may be thorough and complete and the spirit of the present invention may be sufficiently conveyed to those skilled in the art.

In the present specification, it will be understood that when an element is referred to as being "on" another element, it can be formed directly on the other element or intervening elements may be present. In the drawings, the shapes and the thicknesses of regions are exaggerated for clarity.

In addition, it will be also understood that although the terms first, second, third, etc. may be used herein to describe various elements, these elements should not be limited by these terms. These terms are only used to distinguish one element from another element. Thus, a first element in some embodiments may be termed a second element in other embodiments without departing from the teachings of the present invention. Embodiments explained and illustrated herein include their complementary counterparts. As used herein, the term "and/or" includes any and all combinations of one or more of the associated listed elements.

The singular expression also includes the plural meaning as long as it does not differently mean in the context. In addition, the terms "comprise", "have" etc., of the description are used to indicate that there are features, numbers, steps, elements, or combination thereof, and they should not exclude the possibilities of combination or addition of one or more features, numbers, operations, elements, or a combination thereof. Furthermore, it will be understood that when an element is referred to as being "connected" or "coupled" to another element, it may be directly connected or coupled to the other element or intervening elements may be present.

In addition, the terms " ... unit," " ... or/er," "module", and the like used herein indicate a unit for processing at least one function or operation, which may be implemented by hardware, software, or a combination thereof.

In addition, when detailed descriptions of related known functions or constitutions are considered to unnecessarily cloud the gist of the present invention in describing the present invention below, the detailed descriptions will not be included.

Conventionally, metal materials have been used in a method for manufacturing a dielectric.

Meanwhile, the metal material-based dielectric as described above is required to be stretchable in order to be applied to recent flexible systems. The flexible system herein may mean a system having elasticity, and may include wearable devices, for example.

However, as described above, when the dielectric is based only on the metal material, it is obvious that it is difficult to have elasticity.

Accordingly, conventionally, a dielectric including a material having elasticity, for example, a polymer elastomer, together with the metal material as described above, has been developed.

However, when the existing stretchable dielectric material is stretched, the dielectric constant may change irregularly.

Since the existing stretchable dielectric is irregularly changed in dielectric constant as described above, it may be difficult to apply the conventional stretchable dielectric to flexible systems as a substrate.

This may be because the frequency needs to be maintained within a reference range in a high-frequency device of the flexible systems, for example, an antenna.

However, as described above, since the dielectric constant is irregularly changed when the existing stretchable dielectric is stretched, in a case where the stretchable dielectric is manufactured as an antenna, when the manufactured antenna is stretched, the frequency may not be maintained within the reference range and may be changed. For example, when the existing stretchable dielectric is used as a substrate of an antenna, the frequency of the antenna may be lowered when the stretchable dielectric is stretched in a direction in which the substrate is stretched.

Accordingly, in the case of an antenna manufactured using the existing stretchable dielectric as a substrate, the dielectric constant may be formed while having elasticity, but when the antenna is stretched as described above, the frequency is changed, so that it may be difficult to operate at a specific frequency.

Thus, the present invention provides an antenna in which a frequency is substantially maintained within a reference range even when the antenna is stretched.

Hereinafter, an antenna according to an embodiment of the present invention will be described with reference to the drawings.

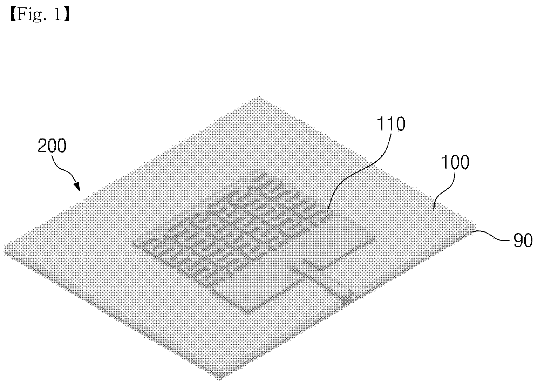

FIG. 1 is a view for explaining an antenna according to an embodiment of the present invention.

Referring to FIG. 1, an antenna 200 may include at least one of a composite substrate 100, a ground panel 90, and a patch 110.

Hereinafter, the respective configurations will be described.

## Composite Substrate 100

According to the embodiment of the present invention, the composite substrate 100 may have elasticity and dielectric properties.

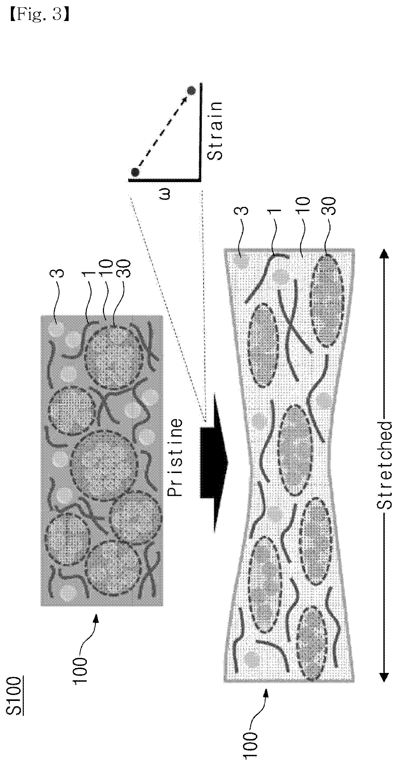

To this end, as shown in FIG. 3, the composite substrate 100 may include at least one of a stretchable polymer 1, a stretchable polymer matrix 10, dielectric powder 3, and a dielectric cluster 30.

Hereinafter, configurations of the composite substrate 100 will be described.

Stretchable Polymer 1

According to the embodiment of the present invention, the stretchable polymer 1 may form the stretchable polymer matrix 10 to be described later.

To this end, the stretchable polymer 1 may be a material having elasticity.

According to one embodiment, the stretchable polymer 1 may include a silicon-based material. For example, the silicon-based material may include ecoflex. However, the stretchable polymer 1 is not limited to the above-described ecoflex, and is not limited as long as the stretchable polymer 1 is a silicon-based material as described above. For example, the stretchable polymer 1 may be polydimethylsiloxane (PDMS) or styrene-ethylene-butylene-styrene (SEBS).

Accordingly, according to the present invention, the stretchable polymer matrix 10 to be described later may have elasticity because the stretchable polymer matrix 10 includes the stretchable polymer 1, that is, a silicon-based material.

Stretchable Polymer Matrix 10

According to the embodiment of the present invention, the stretchable polymer matrix 10 may impart elasticity to the composite substrate 100.

To this end, the stretchable polymer matrix 10 may be formed of the stretchable polymer 1.

Accordingly, as described above, the stretchable polymer matrix 10 may have elasticity.

Meanwhile, referring to FIG. 3, the stretchable polymer matrix 10 may include at least one of the dielectric powder 3 to be described later and the dielectric cluster 30 formed from the dielectric powder 3. The dielectric powder 3 will be described in more detail.

Dielectric Powder 3

According to the embodiment of the present invention, the dielectric powder 3 may impart dielectric properties to the composite substrate 100.

To this end, the dielectric powder 3 may be a material having dielectric properties.

According to one embodiment, the dielectric powder 3 may include a metal oxide-based material. For example, the metal oxide-based material may be at least one selected from metal oxide-based materials including barium titanate, strontium titanate, and aluminum oxide. However, the dielectric powder 3 is not limited to the barium titanate, the strontium titanate, and the aluminum oxide described above, and is not limited as long as the dielectric powder 3 is a metal oxide-based material as described above.

Accordingly, according to the present invention, the dielectric cluster 30 to be described later may have dielectric properties because the dielectric cluster 30 includes the dielectric powder 3, that is, a metal oxide-based material.

Dielectric Cluster 30

According to the embodiment of the present invention, the dielectric cluster 30 may vary a dielectric constant ε (see the graph of FIG. 3) of the composite substrate 100.

To this end, the dielectric cluster 30 may be formed of the dielectric powder 3 and have a predetermined shape as shown in FIG. 3. The predetermined shape herein is not limited as long as dielectric powders 3 are formed adjacent to each other. For example, the predetermined shape herein may include a circle, a polygon, and the like formed by the dielectric powders 3 adjacent to each other.

Referring to FIG. 3, when the antenna 200 is stretched, the predetermined shape of the dielectric cluster 30 may be changed so that the dielectric constant ε may be varied.

This may be because the dielectric cluster 30 is included in the stretchable polymer matrix 10 as described above.

More specifically, as shown in FIG. 3, when the stretching proceeds in an elongation direction (stretched), the predetermined shape of the dielectric cluster 30 may be changed such that the number of dielectric powders 3 per unit volume of the stretchable polymer matrix 10 decreases.

Accordingly, when the stretching proceeds in an elongation direction (stretched) as shown in the graph of FIG. 3, the dielectric constant ε may substantially decrease linearly and rapidly.

That is, when the composite substrate 100 according to the embodiment of the present invention is stretched as shown in FIG. 3, the predetermined shape of the dielectric cluster 30 may be changed so that the dielectric constant ε may be varied.

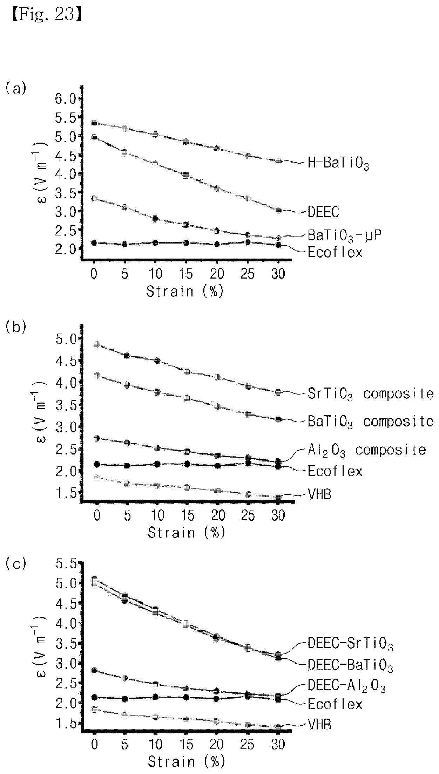

More specifically, according to an experimental example of the present invention, the composite substrate 100 may have a variable dielectric constant ε (see DEEC on y-axis of FIG. 23(a)) in a stretch range (strain, see DEEC on x-axis of FIG. 23(a)) of 0.1% to 30%. In this case, referring to FIG. 23(a), a range of the variable dielectric constant ε may be 1.5 to 7.5 (see DEEC on y-axis of FIG. 23(a)). The dielectric constant ε herein may mean a relative dielectric constant.

Meanwhile, referring to FIG. 23(a), the dielectric constant ε (x-axis of FIG. 23(a)) of the composite substrate 100 or DEEC may rapidly decrease with a gradient in a range of 0.03 to 0.08 in the stretch range (strain, y-axis of FIG. 23(a)) of 0.1% to 30%.

Accordingly, according to the present invention, when the antenna 200 including the composite substrate 100 may have excellent frequency characteristics.

More specifically, typically, in the antenna, a frequency needs to be substantially maintained within a reference range, and in this case, the frequency may follow Equation 1 below:

<Equation 1>

$$fr = \frac{c}{2L_1 \sqrt{\varepsilon_r}}$$

(where $f_r$ is a frequency, c is a speed of light, $L_1$ is a stretched length, and $\varepsilon_r$ is a dielectric constant).

According to Equation 1, when the antenna 200 is stretched, for example, is stretched in an elongation direction, the dielectric constant needs to be decreased in order to maintain a constant frequency.

More specifically, according to <Equation 1>, when the antenna 200 is stretched in an elongation direction as described above, the dielectric constant needs to be decreased by the square of the stretched length.

Therefore, in order to maintain a constant frequency, the antenna 200 may require a gradient in which the dielectric constant rapidly decreases by the square with respect to the stretched length.

Meanwhile, according to the present invention, as described above, the dielectric constant ε (see x-axis of FIG. 23(a)) of the composite substrate 100 or DEEC may rapidly decrease with a gradient in a range of 0.03 to 0.08 in the stretch range (strain, see y-axis of FIG. 23(a)) of 0.1% to 30%.

Accordingly, according to the present invention, when the antenna 200 including the composite substrate 100 may have excellent frequency characteristics because the antenna 200 may maintain a constant frequency. The experimental examples of the present invention will be described below in more detail.

Meanwhile, according to the embodiment of the present invention, the composite substrate 100 may have an excellent thermal conductivity.

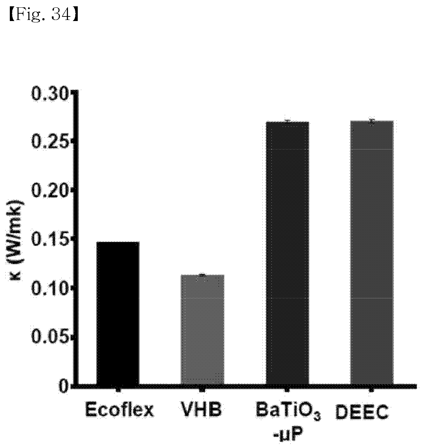

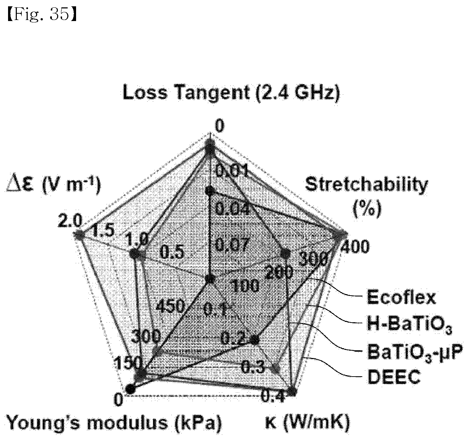

More specifically, according to the experimental example of the present invention, as shown in FIGS. 34 and 35, the composite substrates 100 and DEEC may have a thermal conductivity of 0.1 W/mk to 10 W/mk.

This may be because, according to the present invention, the composite substrate 100 includes the dielectric powder 3 as described above.

Accordingly, according to the present invention, when the antenna 200 including the composite substrate 100 may have excellent thermal conductivity characteristics. The experimental examples of the present invention will be described below in more detail.

**Ground Panel 90**

According to the embodiment of the present invention, the ground panel 90 may be grounded.

To this end, the ground panel 90 may be formed on a lower surface of the composite substrate 100 as shown in FIG. 1.

According to one embodiment, the ground panel 90 may be formed of a metal conductor material having elasticity. For example, the metal conductor material having elasticity may include silver. However, the ground panel 90 is not limited to the sliver described above, and is not limited as long as the ground panel 90 is a metal conductor material having elasticity as described above. For example, the metal conductor material having elasticity may be copper, gold, or aluminum.

**Patch 110**

According to the embodiment of the present invention, the patch 110 may receive radio waves from the outside or transmit electrical signals generated by a specific device to the outside. The term "outside" herein may include, for example, a base station, a relay, and a communication device, and the term "specific device" may include a communication device.

To this end, the patch 110 may be formed on an upper surface of the composite substrate 100 to resonate at a frequency in a reference range.

According to one embodiment, the patch 110 may be formed of a metal conductor material having elasticity. For example, the metal conductor material having elasticity may include silver. However, the patch 110 is not limited to the sliver described above, and is not limited as long as the patch 110 is a metal conductor material having elasticity as described above. For example, the metal conductor material having elasticity may be copper, gold, or aluminum.

Meanwhile, according to one embodiment, the patch 110 may include a pattern.

Accordingly, the patch 110 may have different resonant frequency characteristics. This will be described below in more detail in the experimental examples of the present invention.

Meanwhile, according to the embodiment of the present invention, as described above, since the patch 110 is formed on the upper surface of the composite substrate 100 and is formed of a metal conductor material having elasticity, when the antenna 200 is stretched, the patch 110 may be stretched together with the composite substrate 100.

In this case, according to the present invention, even when the antenna 200 is stretched as described above, the frequency may be substantially maintained within the reference range.

This may be because the composite substrate 100 of the antenna 200 includes the dielectric cluster 30 as described above.

More specifically, when the antenna 200 is stretched, the shape of the dielectric cluster 30 may be changed so that the dielectric constant may be varied. For example, as shown in FIG. 3, when the stretching proceeds in an elongation direction (stretched), the predetermined shape of the dielectric cluster 30 may be changed such that the number of dielectric powders 3 per unit volume of the stretchable polymer matrix 10 decreases.

Accordingly, when the stretching proceeds in an elongation direction (stretched) as described, the dielectric constant ε may decrease linearly and rapidly.

Typically, the frequency in the antenna may follow Equation 1 described above.

As described above, according to Equation 1, when the antenna 200 is stretched, for example, is stretched in an elongation direction, the dielectric constant needs to be decreased in order to maintain a constant frequency.

More specifically, according to <Equation 1>, when the antenna 200 is stretched in an elongation direction as described above, the dielectric constant needs to be decreased by the square of the stretched length.

Therefore, in order to maintain a constant frequency, the antenna 200 may require a gradient in which the dielectric constant rapidly decreases by the square with respect to the stretched length.

Meanwhile, according to the present invention, as described above, the dielectric constant of the composite substrate 100 may decrease linearly and rapidly when the stretching proceeds in an elongation direction.

Accordingly, according to the present invention, when the antenna 200 including the composite substrate 100 may have excellent frequency characteristics because the antenna 200 may maintain a constant frequency.

Meanwhile, unlike the embodiment of the present invention, when the existing antenna is stretched, the frequency may not be maintained within the reference range and may be changed.

This may be because the existing antenna includes an existing stretchable dielectric having a dielectric constant that changes irregularly as described above.

Accordingly, the existing antenna may form the dielectric constant while having elasticity, but when the antenna is stretched as described above, the frequency is changed, so that it may be difficult to operate at a specific frequency.

However, according to the embodiment of the present invention, as described above, since the antenna 200 includes the dielectric cluster 30, the frequency may be maintained within the reference range even when the antenna 200 is stretched, and thus, the antenna 200 may be easily operated at a specific frequency.

Hereinabove, the antenna 200 according to the embodiment of the present invention has been described.

Hereinafter, a method for manufacturing the antenna 200 according to the embodiment of the present invention will be described with reference to the drawings.

Hereinafter, in the method for manufacturing the antenna 200 to be described, a description overlapping with the description of the above-described embodiment may be omitted. However, in the following description, overlapping descriptions are omitted, and the overlapping descriptions refer to the descriptions of the previous embodiments.

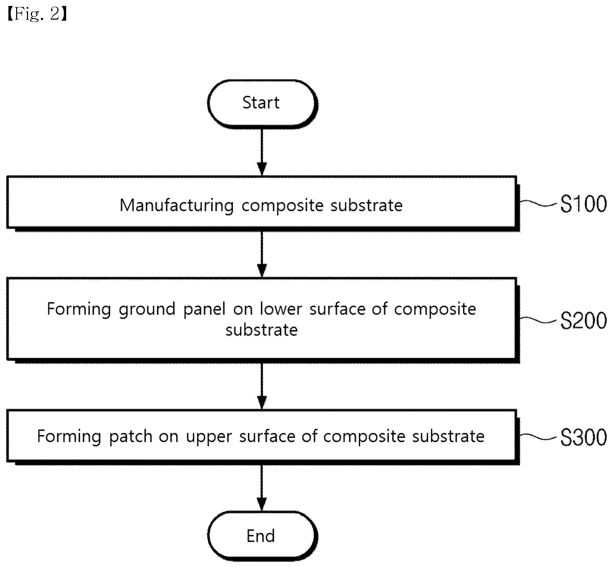

FIGS. 2 to 10 are views for explaining a method for manufacturing an antenna according to the embodiment of the present invention.

Referring to FIG. 2, the method for manufacturing the antenna 200 may include at least of a step S100 of preparing the composite substrate 100, a step S200 of forming the ground panel 90 on the lower surface of the composite substrate 100, and a step S300 of forming the patch 110 on the upper surface of the composite substrate 100.

Hereinafter, the respective steps will be described.

## Step S100

Referring to FIG. 3, in step S100, the composite substrate 100 may be prepared.

The composite substrate 100 prepared in this step may have elasticity and dielectric properties as described above.

To this end, in this step, the preparation of the composite substrate 100 may include steps S110 to S140, which will be described below.

Hereinafter, detailed steps of step S100 will be described.

Hereinafter, in the detailed steps of step S100, a description overlapping with the description of the above-described embodiment may be omitted. However, in the following description, overlapping descriptions are omitted, and the overlapping descriptions refer to the descriptions of the previous embodiments.

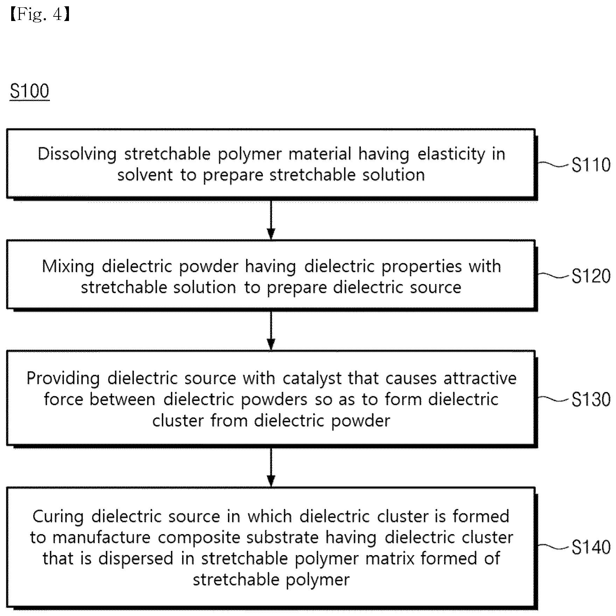

Referring to FIG. 4, step S100 may include any one of a step S110 of dispersing thee stretchable polymer 1 having elasticity in a solvent to prepare a source solution, a step S120 of mixing the dielectric powder 3 having dielectric properties with the source solution to prepare a dielectric source, a step S130 of providing the dielectric source with a catalyst that causes an attractive force between dielectric powders 3 so as to form the dielectric cluster 30 having a predetermined shape from the dielectric powders 3, and a step S140 of curing the dielectric source in which the dielectric cluster is formed to manufacture the composite substrate 100 having the dielectric cluster 30 that is dispersed in the stretchable polymer matrix 10 formed of the stretchable polymer 1.

Hereinafter, the respective steps will be described.

## Step S110

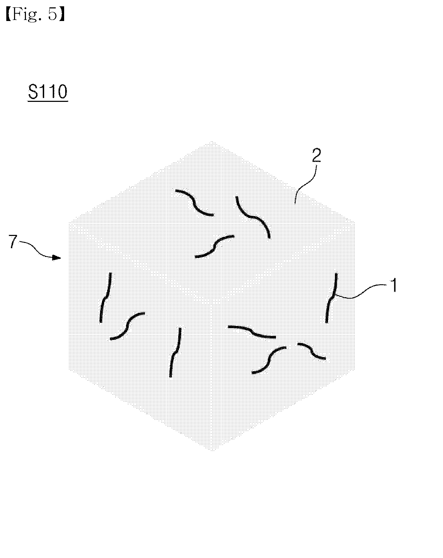

Referring to FIG. 5, in step S110, the stretchable polymer 1 having elasticity may be dispersed in a solvent 2 to prepare a source solution 7.

More specifically, in this step, the stretchable polymer 1 may be prepared by mixing a main agent and a curing agent at the same mass ratio, for example, a mass ratio of 1:1.

Meanwhile, in this step, the prepared stretchable polymer 1 may be dispersed in the solvent 2.

According to one embodiment, in this step, the solvent 2 may be a polar liquid that is non-miscible with water. For example, the polar liquid may include dichloromethane. However, the solvent 2 is not limited to the dichloromethane described above, and is not limited as long as the solvent 2 is a polar liquid that is non-miscible with water.

Meanwhile, in this step, the stretchable polymer 1 may be a silicon-based material, as described above. In this regard, since the descriptions overlap with the descriptions of the previous embodiment, the overlapping descriptions will refer to the descriptions of the previous embodiment.

## Step S120

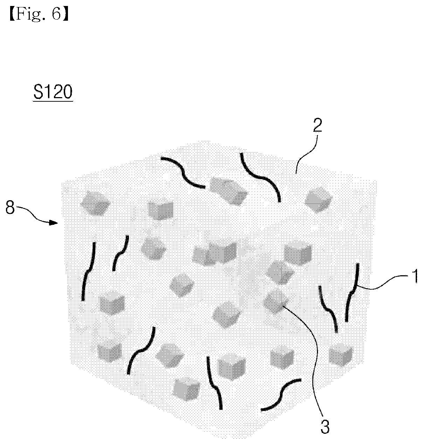

Referring to FIG. 6, in step S120, the dielectric powder 3 having dielectric properties may be mixed with the source solution 7 (see FIG. 5) to prepare a dielectric source 8.

More specifically, in this step, the dielectric powder 3 may have a nanoparticle size. For example, the dielectric powder 3 may have a size of 100 nm.

According to one embodiment, in this step, the dielectric powder 3 may be a metal oxide-based material. In this regard, since the descriptions overlap with the descriptions of the previous embodiment, the overlapping descriptions will refer to the descriptions of the previous embodiment.

## Step S130

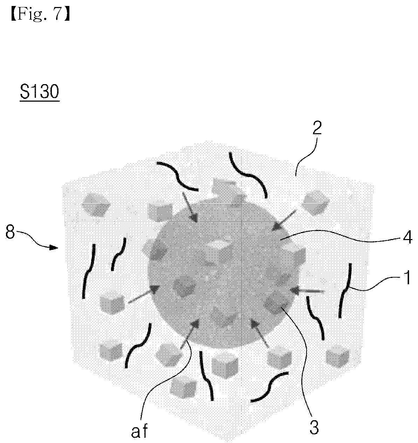

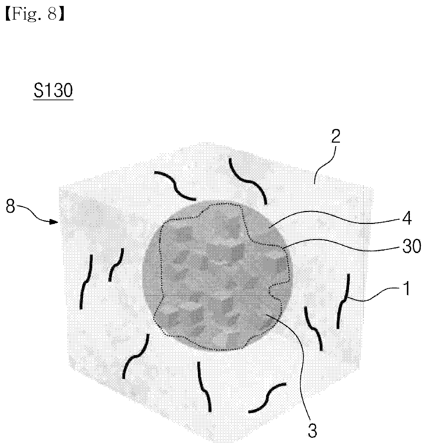

Referring to FIGS. 7 and 8, in step S130, the dielectric source 8 may be provided with a catalyst 4 that causes an attractive force af between dielectric powders 3, so that the dielectric cluster 30 having a predetermined shape may be formed from the dielectric powders 3.

More specifically, in this step, the catalyst 4 may be provided to the dielectric source 8 by a dripping method. The dripping method herein may be understood as a concept that includes dripping the catalyst 4 to the dielectric source 8 and providing the catalyst 4 as liquid droplets.

Accordingly, as shown in FIG. 7, when the catalyst 4 is provided to the dielectric source 8 as the liquid droplets, the attractive force af may be generated between dielectric powders 3, and as shown in FIG. 8, the dielectric cluster 30 having a predetermined shape may be formed of the dielectric powders 3. The predetermined shape herein is not limited as long as dielectric powders 3 are formed adjacent to each other. In this regard, since the descriptions overlap with the descriptions of the previous embodiment, the overlapping descriptions will refer to the descriptions of the previous embodiment.

Meanwhile, in this step, the catalyst 4 may be provided by the dripping method in a situation where the dielectric source 8 is stirred at a predetermined speed for a predetermined time. For example, in this step, the catalyst 4 may be provided by the dripping method in a situation where the dielectric source 8 is stirred at a speed of 900 rpm to 1100 rpm for 20 minutes.

Therefore, according to the present invention, the dielectric cluster 30 having a predetermined shape may be easily formed.

According to one embodiment, in this step, the catalyst 4 may be water.

## Step S140

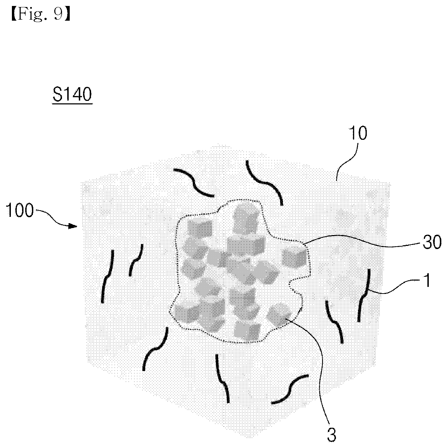

Referring to FIG. 9, in step S140, the dielectric source 8 (see FIG. 8) in which the dielectric cluster 30 is formed may be cured to manufacture the composite substrate 100.

Accordingly, in this step, the composite substrate 100 may have a structure in which the dielectric cluster 30 is dispersed in the stretchable polymer matrix 10 formed from the stretchable polymer 1, as shown in FIG. 9.

Therefore, according to the present invention, when the composite substrate 100 is stretched (see FIG. 3) as described above, the predetermined shape of the dielectric cluster 30 may be changed so that the dielectric constant $\varepsilon$ may be varied.

More specifically, according to the experimental example of the present invention, as described with reference to FIG. 23(a), the dielectric constant $\varepsilon$ (x-axis of FIG. 23(a)) of the composite substrate 100 or DEEC may rapidly decrease with a gradient in a range of 0.03 to 0.08 in the stretch range (strain, y-axis of FIG. 23(a)) of 0.1% to 30%.

Accordingly, according to the present invention, when the antenna 200 including the composite substrate 100 may have excellent frequency characteristics. This may follow Equation 1 as described above.

According to <Equation 1>, as described above, in order to maintain a constant frequency, the antenna 200 may require a gradient in which the dielectric constant rapidly decreases by the square with respect to the stretched length.

Meanwhile, according to the present invention, as described above, the dielectric constant ε (see x-axis of FIG. 23(a)) of the composite substrate 100 or DEEC may rapidly decrease with a gradient in a range of 0.03 to 0.08 in the stretch range (strain, see y-axis of FIG. 23(a)) of 0.1% to 30%.

Accordingly, according to the present invention, when the antenna 200 including the composite substrate 100 may have excellent frequency characteristics because the antenna 200 may maintain a constant frequency. In this regard, since the descriptions overlap with the descriptions of the previous embodiment, the overlapping descriptions will refer to the descriptions of the previous embodiment.

Meanwhile, according to the embodiment of the present invention, the composite substrate 100 may also have an excellent thermal conductivity as described above. This will be described below in more detail in the experimental examples of the present invention.

Hereinafter, the detailed steps of step S100 has been described.

Hereinafter, steps S200 and S300 will be described with reference to FIG. 2 again.

## Step S200

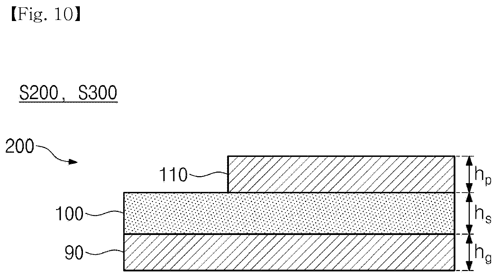

Referring to FIG. 10, in step S200, the ground panel 90 may be formed on the lower surface of the composite substrate 100.

To this end, in this step, the ground panel 90 may be formed by providing the lower surface of the composite substrate 100 with an ink including the metal conductor material having elasticity.

Accordingly, the antenna 200 may be grounded through the ground panel 90.

Since the descriptions related to the ground panel 90 overlap with the descriptions of the previous embodiment, the overlapping descriptions will refer to the descriptions of the previous embodiment.

## Step S300

Referring to FIG. 10, in step S300, the patch 110 may be formed on the upper surface of the composite substrate 100.

To this end, in this step, the metal conductor material having elasticity may be formed on the upper surface of the composite substrate 100 in a pattern having a predetermined shape. The pattern will be described below in more detail in the experimental examples of the present invention.

Accordingly, the antenna 200 may receive radio waves from the outside or transmit electrical signals generated by a specific device to the outside.

Meanwhile, according to the embodiment of the present invention, as described above, the patch 110 may be formed on the upper surface of the composite substrate 100 to resonate at a frequency in a reference range, and in this case, even when the antenna 200 is stretched, the frequency may be maintained within the reference range.

This may be because, as described above, the composite substrate 100 of the antenna 200 includes the dielectric cluster 30 so that the dielectric constant of the composite substrate 100 may be varied.

Since the descriptions related to the patch 110 and the dielectric cluster 30 overlap with the descriptions of the previous embodiment, the overlapping descriptions will refer to the descriptions of the previous embodiment.

Hereinabove, the method for manufacturing the antenna 200 according to the embodiment of the present invention has been described.

The above-described embodiment of the present invention may be applied to a dipole antenna.

Hereinafter, the experimental examples of the present application will be described.

<Manufacture of First Composite Substrates 100, DEEC, DEEC-BaTiO$_3$, And M-BaTiO$_3$ According to Experimental Example of Present Invention>

A main agent and a curing agent were mixed in a mass ratio of 1:1 to prepare ecoflex as the stretchable polymer 1.

12 ml of dichloromethane was prepared as the solvent 2, and 10 g of ecoflex was dispersed in the dichloromethane to prepare the source solution 7.

6 g of barium titanate (BaTiO$_3$) powder having a size of 100 nm, which served as the dielectric powder 3, was mixed with the source solution 7 to prepare the dielectric source 8.

While stirring the dielectric source 8 at a speed of 1000 rpm for 20 minutes, 1 mL of water serving as the catalyst 4 was provided to the dielectric source 8 as liquid droplets through a dripping method so as to form the circular dielectric cluster 30.

The dielectric source 8 in which the dielectric cluster 30 was formed was provided to a mold and cured to manufacture first composite substrates 100, DEEC, DEEC-BaTiO$_3$, and M-BaTiO$_3$ according to the experimental example of the present invention.

<Manufacture of Antennas 200, DEEC, And M-BaTiO$_3$ According to Experimental Example of Present Invention>

The ground panel 90 was formed on the lower surface of the first composite substrates 100, DEEC, DEEC-BaTiO$_3$, and M-BaTiO$_3$, which were manufactured by the method for manufacturing the first composite substrate according to the experimental example of the present invention described above, by using a silver ink as the metal conductor material having elasticity.

Meanwhile, the patch 110 was formed on the upper surface of the first composite substrates 100, DEEC, DEEC-BaTiO$_3$, and M-BaTiO$_3$ by using a silver ink as the metal conductor material having elasticity to manufacture the antennas 200, DEEC, And M-BaTiO$_3$ according to the experimental example of the present invention.

<Manufacture of Second Composite Substrate DEEC-SrTiO$_3$ According to Experimental Example of Present Invention>

In the method for manufacturing the first composite substrate according to the experimental example of the present invention described above, strontium titanate (SrTiO$_3$) was mixed instead of the barium titanate (BaTiO$_3$) to manufacture a second composite substrate DEEC-SrTiO$_3$ according to the experimental example of the present invention.

<Manufacture of Third Composite Substrate DEEC-Al$_2$O$_3$ According to Experimental Example of Present Invention>

In the method for manufacturing the first composite substrate according to the experimental example of the present invention described above, aluminum oxide (Al$_2$O$_3$) was mixed instead of the barium titanate (BaTiO$_3$) to manufacture a third composite substrate DEEC-Al$_2$O$_3$ according to the experimental example of the present invention.

<Preparation of First Stretchable Polymer Ecoflex According to Comparative Example>

In the method for manufacturing the first composite substrate according to the experimental example of the present invention described above, only ecoflex was prepared as the stretchable polymer to prepare a first stretchable polymer Ecoflex according to the comparative example.

<Manufacture of First Antenna Ecoflex According to Comparative Example>

In the method for manufacturing the antenna according to the experimental example of the present invention described above, instead of the first composite substrate, a first antenna Ecoflex according to the comparative example was manufactured using the first stretchable polymer Ecoflex according to the comparative example described above.

<Preparation of Second Stretchable Polymer VHB According to Comparative Example>

In the method for manufacturing the first composite substrate according to the experimental example of the present invention described above, ecoflex and a polyacrylate-based polymer were prepared as stretchable polymers to prepare a second stretchable polymer VHB according to the comparative example.

<Manufacture of First Substrate BaTiO$_3$-$\mu$P According to Comparative Example>

In the method for manufacturing the first composite substrate according to the experimental example of the present invention described above, water was not provided, and micro-sized barium titanate (BaTiO$_3$) powder serving as dielectric powder was mixed to manufacture a first substrate BaTiO$_3$-$\mu$P according to the comparative example.

<Manufacture of Second Substrates H-BaTiO$_3$, BaTiO$_3$-composite, And BaTiO$_3$ According to Comparative Example>

In the method for manufacturing the first composite substrate according to the experimental example of the present invention described above, second substrates H-BaTiO$_3$, BaTiO$_3$-composite, and BaTiO$_3$ according to the comparative example were manufactured without providing water.

<Manufacture of Second Antenna BaTiO$_3$ According to Comparative Example>

In the method for manufacturing the antenna according to the experimental example of the present invention described above, instead of the first composite substrate, a second antenna BaTiO$_3$ according to the comparative example was manufactured using the second substrates H-BaTiO$_3$, BaTiO$_3$-composite, and BaTiO$_3$ according to the comparative example described above.

<Manufacture of Third Substrate SrTiO$_3$-composite According to Comparative Example>

In the method for manufacturing the second substrate according to the comparative example described above, strontium titanate (SrTiO$_3$) was mixed instead of barium titanate (BaTiO$_3$) to manufacture a third substrate SrTiO$_3$-composite according to the comparative example.

<Manufacture of Fourth Substrate Al$_2$O$_3$-composite According to Comparative Example>

In the method for manufacturing the second substrate according to the comparative example of the present invention described above, aluminum oxide (Al$_2$O$_3$) was mixed instead of barium titanate (BaTiO$_3$) to manufacture a fourth substrate Al$_2$O$_3$-composite according to the comparative example.

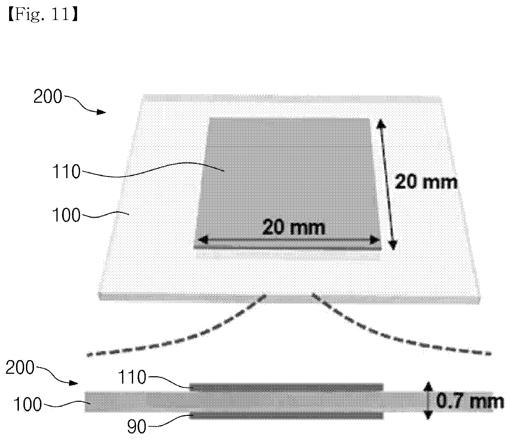

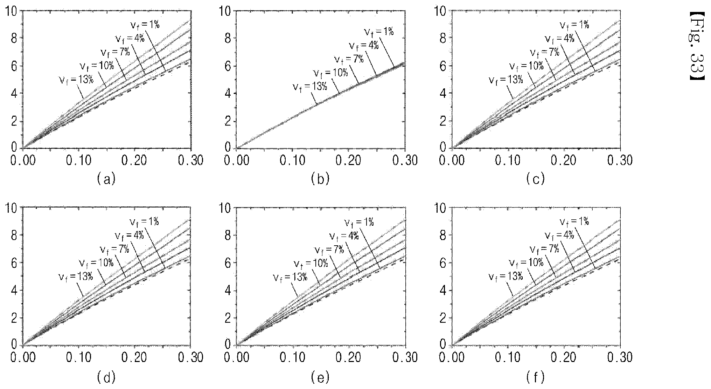

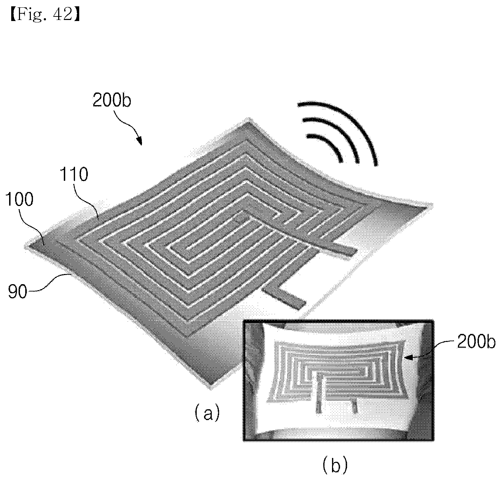

FIGS. 11 to 66 are views for explaining experimental examples of the present invention.

FIG. 11 is an experimental conceptual view of the antenna 200 according to the experimental example of the present invention.

Referring to FIG. 11, in order to manufacture the antenna 200 according to the experimental example of the present invention, the ground panel 90 was formed on the lower surface of the first composite substrate 100 by using a silver ink as the metal conductor material having elasticity.

Meanwhile, the patch 110 was formed on the upper surface of the first composite substrate 100 by using a silver ink as the metal conductor material having elasticity.

In this case, the ground panel 90 and the patch 110 were manufactured to have the same width of 20 mm and the same length of 20 mm, and the first composite substrate 100 was manufactured to have a thickness of 0.7 mm.

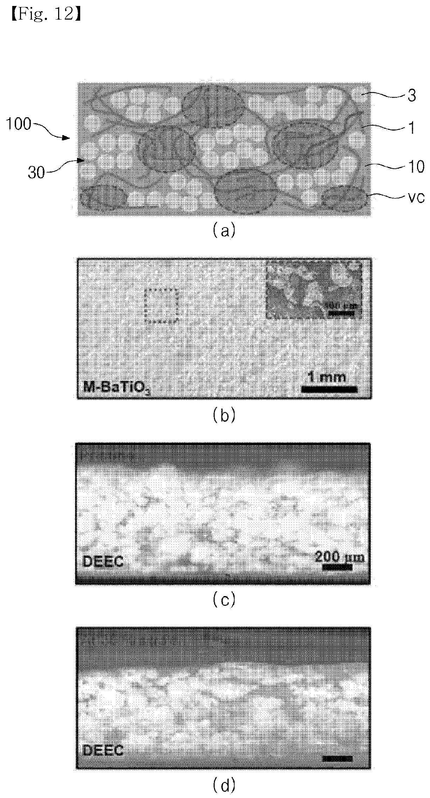

FIGS. 12(a) to 12(d) are photographs of the first composite substrates 100 and M-BaTiO$_3$ according to the experimental example of the present invention.

Through FIGS. 12(a) to 12(d), it may be proved that the first composite substrates 100 and M-BaTiO$_3$ include the dielectric cluster 30.

In addition, referring to FIGS. 12(a) to 12(d), since the first composite substrate 100 includes the dielectric cluster 30, it may also be observed that empty spots, that is, vacancies vc, which are moved by the attractive force af between the dielectric powders 3, are formed between the dielectric clusters 30.

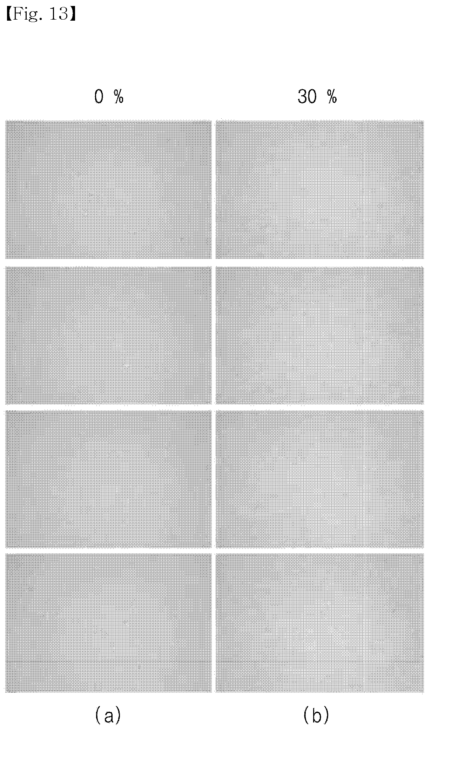

FIG. 13(a) is a photograph of the first composite substrate 100 according to the experimental example of the present invention before stretching, and FIG. 13(b) is a photograph of the first composite substrate 100 according to the experimental example of the present invention, which is stretched by 30%.

Through FIG. 13(a), the dielectric cluster 30 dispersed in the first composite substrate 100 may be observed.

Furthermore, through FIG. 13(b), when the first composite substrate 100 is stretched, a change in shape of the dielectric cluster 30 may be observed.

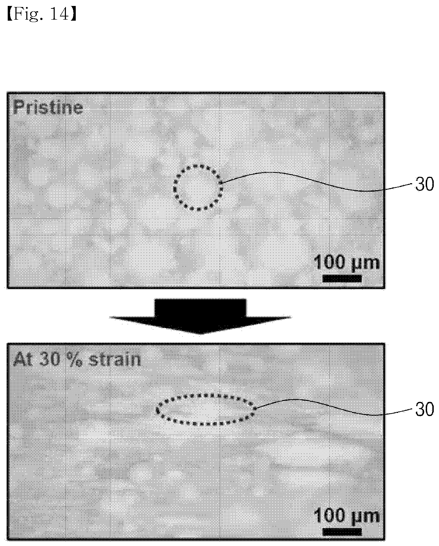

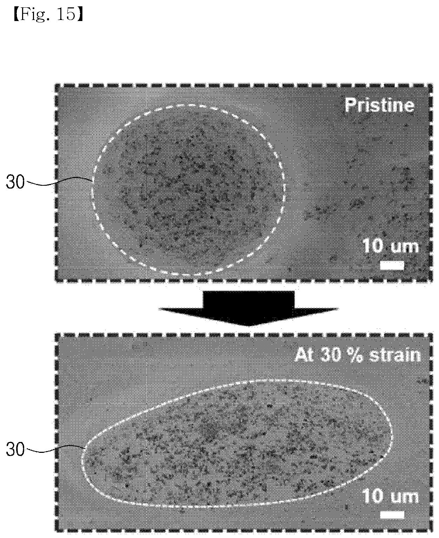

FIG. 14 is a 100 μm scale photograph of the first composite substrate 100 according to the experimental example of the present invention, before stretching and after stretched by 30%, and FIG. 15 is a 10 μm scale photograph of the first composite substrate 100 according to the experimental example of the present invention, before stretching and after stretched by 30%.

Referring to FIGS. 14 and 15, it may be observed that the shape of the dielectric cluster 30 in the first composite substrate 100 is changed.

More specifically, it may be observed that the dielectric cluster 30 having a circular shape before stretching is changed into an elliptical shape after stretched by 30% in the first composite substrate 100.

Accordingly, when the first composite substrate 100 is stretched, it may be proved that the shape of the dielectric cluster 30 is changed such that the number of the dielectric powders 3 per unit volume of the stretchable polymer matrix 10 decreases.

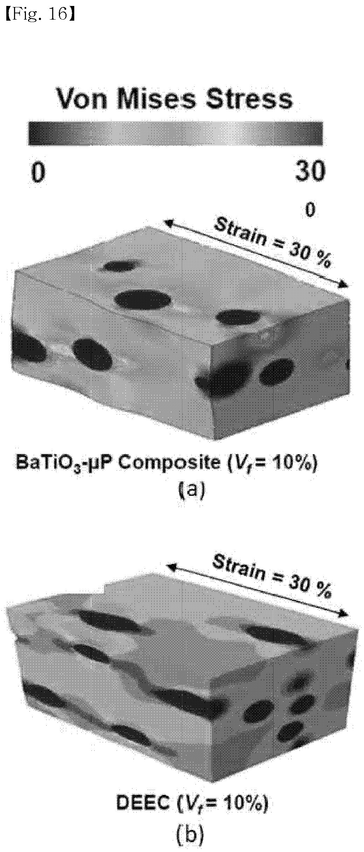

FIG. 16(a) is an elasticity simulation result when the first substrate BaTiO$_3$-μP according to the comparative example is stretched by 30%, and FIG. 16(b) is an elasticity simulation result when the first composite substrate DEEC according to the experimental example of the present invention is stretched by 30%.

Referring to FIGS. 16(a) and 16(b), it may be proved that elasticity of the first composite substrate DEEC is superior to that of the first substrate BaTiO$_3$-μP.

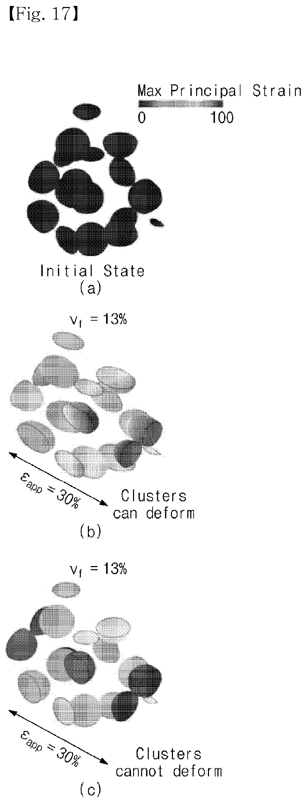

FIG. 17(a) is a simulation result of the first composite substrate 100 according to the experimental example of the present invention before stretching, FIG. 17(b) is a simulation result of the first composite substrate 100 according to the experimental example of the present invention, which is stretched by 30%, when a volume ratio occupied by the dielectric powder 3 is 13% (13 vol%), and FIG. 17(c) is a simulation result of the first substrate BaTiO$_3$-μP according to the comparative example, which is stretched by 30%, when a volume ratio occupied by the dielectric powder is 13% (13 vol%).

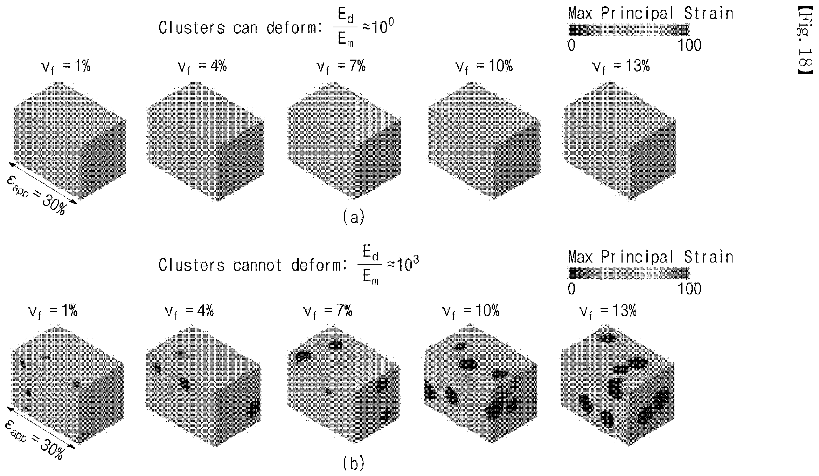

FIG. 18(a) is a simulation result of the first composite substrate 100 according to the experimental example of the present invention, which is stretched by 30%, when a volume ratio occupied by the dielectric powder 3 is 1% to 13% (1 to 13 vol%), and FIG. 18(b) is a simulation result of the first substrate $BaTiO_3$-$\mu$P according to the comparative example, which is stretched by 30%, when a volume ratio occupied by the dielectric powder 3 is 1% to 13% (1 to 13 vol%).

Through FIGS. 17(a) to 18(b), it may be proved that elasticity of the first composite substrate DEEC is superior to that of the first substrate $BaTiO_3$-$\mu$P.

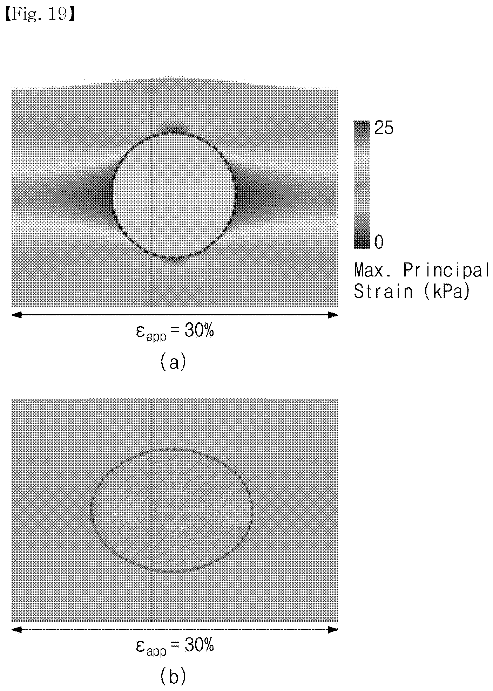

FIG. 19(a) is an elasticity simulation result when the first substrate $BaTiO_3$-$\mu$P according to the comparative example is stretched by 30%, and FIG. 19(b) is an elasticity simulation result when the first composite substrate 100 according to the experimental example of the present invention is stretched by 30%.

Referring to FIGS. 19(a) and 19(b), it may be proved that elasticity of the first composite substrate DEEC is superior to that of the first substrate $BaTiO_3$-$\mu$P.

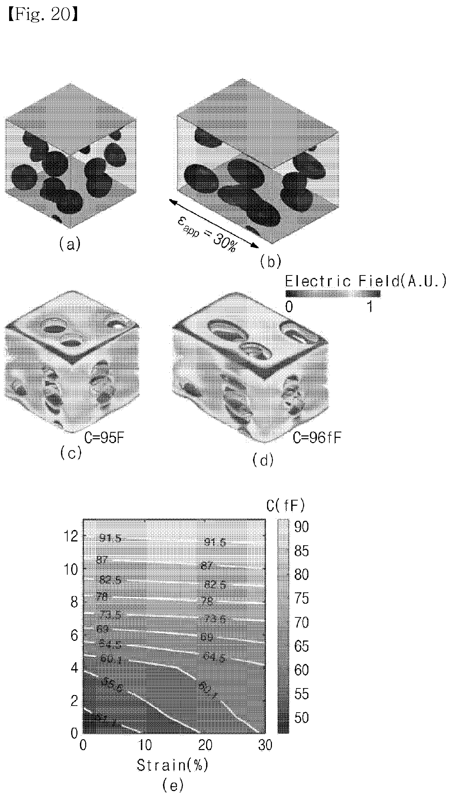

FIGS. 20(a) and 20(c) are capacitance simulation results of the first composite substrate 100 according to the experimental example of the present invention before stretching, FIGS. 20(b) and 20(d) are capacitance simulation results when the first composite substrate 100 according to the experimental example of the present invention is stretched by 30%, and FIG. 20(e) is a capacitance simulation legend.

Referring to FIGS. 20(a) to 20(e), it may be proved that the first composite substrate 100 has a uniform capacitance distribution even when the first composite substrate 100 is stretched by 30%.

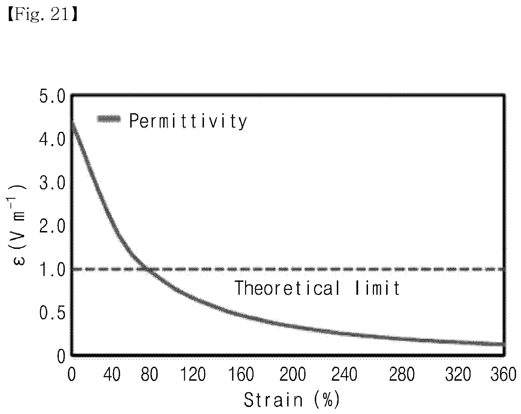

FIG. 21 is a dielectric constant (permittivity) change simulation curve required when a substrate having elasticity and dielectric properties is stretched.

Referring to FIG. 21, when a theoretical limit is excluded from a substrate having elasticity and a dielectric constant, a simulation result shows that dielectric constant may decrease with a gradient in a range of 0.043 to 0.044 in a stretch range of 0.1% to 80%.

Referring to FIG. 23(a), this is a result of a gentle gradient as compared to a case where the dielectric constant of the first composite substrate DEEC according to the experimental example of the present invention, which will be described later, decreases with a gradient in a range of 0.03 to 0.08 in a stretch range of 0.1% to 30%.

Therefore, according to the experimental example of the present invention, it may be proved that the first composite substrate DEEC has a dielectric constant that rapidly decreases as compared to the simulation result.

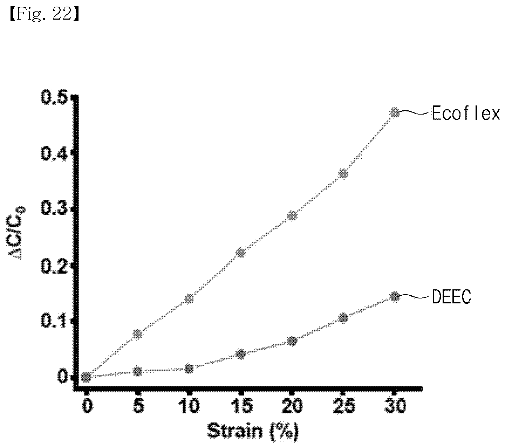

FIG. 22 is a result of measuring a change in capacitance according to elongation of the first composite substrate DEEC according to the experimental example of the present invention and the first stretchable polymer Ecoflex according to the comparative example.

Referring to FIG. 22, it may be proved that the first composite substrate DEEC may have a capacitance change less than that of the first substrate polymer Ecoflex when the first composite substrate DEEC is stretched by 30%.

FIG. 23(a) is a result of measuring dielectric constants $\varepsilon$ of the first composite substrate DEEC according to the experimental example of the present invention, the first substrate $BaTiO_3$-$\mu$P according to the comparative example, the second substrate H-$BaTiO_3$ according to the comparative example, and the first stretchable polymer Ecoflex according to the comparative example, in a stretch (strain) range of 0.1% to 30%.

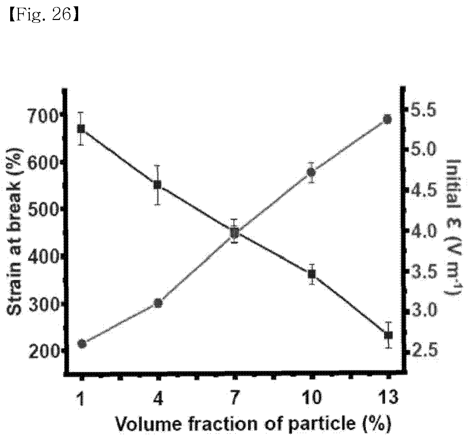

Referring to FIG. 23(a), it can be seen that the first composite substrate DEEC has a variable dielectric constant range as described above in the stretch range of 0.1% to 30%. More specifically, it can be seen that the first composite substrate DEEC has a variable dielectric constant in a range of 1.5 to 7.5 as shown in FIG. 26.

In addition, referring to FIG. 23(a), it can be seen that the dielectric constant of the first composite substrate DEEC rapidly decreases with a gradient in a range of 0.03 to 0.08 in the stretch range of 0.1% to 30%.

Therefore, according to the present invention, the first composite substrates DEEC and 100 may have excellent frequency characteristics when the first composite substrates DEEC and 100 are applied to the antenna 200 as described above.

This may be because, according to the experimental example of the present invention, when the first composite substrates DEEC and 100 are stretched as described above, the shape of the dielectric cluster 30 is changed so that the dielectric constant is varied.

Meanwhile, it can be seen that the gradients of the second substrate H-$BaTiO_3$, the first substrate $BaTiO_3$-$\mu$P, and the first stretchable polymer Ecoflex are gentle as compared to the experimental example of the present invention.

Among the second substrate H-$BaTiO_3$, the first substrate $BaTiO_3$-$\mu$P, and the first stretchable polymer Ecoflex, as can be seen in the second substrate H-$BaTiO_3$ having a gradient that most rapidly decreases, the dielectric constant of the second substrate H-$BaTiO_3$ decreases with a gradient in a range of 0.025 in the stretch range of 0.1% to 30%.

Therefore, referring to the fact that the dielectric constant decreases with a gradient of 0.043 to 0.044 in the stretch range of 0.1% to 80% as the above-described simulation result with reference to FIG. 21, it may be proved that the gradient most rapidly decreases in the experimental example of the present invention.

FIG. 23(b) is a result of measuring dielectric constants $\varepsilon$ of the second substrate $BaTiO_3$-composite according to the comparative example, the third substrate $SrTiO_3$-composite according to the comparative example, the fourth substrate $Al2O_3$-composite according to the comparative example, the first stretchable polymer Ecoflex according to the comparative example, and the second stretchable polymer VHB according to the comparative example, in a stretch (strain) range of 0.1% to 30%.

Referring to FIG. 23(b), it can be seen that when barium titanate ($BaTiO_3$) and strontium titanate ($SrTiO_3$) are included as the dielectric powder 3, the dielectric constant decreases with a steeper gradient as compared to other comparative examples in the stretch range of 0.1% to 30%.

Therefore, when barium titanate ($BaTiO_3$) and/or strontium titanate ($SrTiO_3$) are included as the dielectric powder 3, it may be proved that the dielectric powder has excellent dielectric constant characteristics for stretching.

FIG. 23(c) is a result of measuring dielectric constants $\varepsilon$ of the first composite substrate DEEC-$BaTiO_3$ according to the experimental example of the present invention, the second composite substrate DEEC-$SrTiO_3$ according to the experimental example of the present invention, the third composite substrate DEEC-$Al_2O_3$ according to the experimental example of the present invention, the first stretchable polymer Ecoflex according to the comparative example, and the second stretchable polymer VHB according to the comparative example, in a stretch (strain) range of 0.1% to 30%.

Referring to FIG. 23(c), it can be seen that the dielectric constants of the first and second composite substrates DEEC-$BaTiO_3$ and DEEC-$SrTiO_3$ rapidly decrease with a gradient in a range of 0.03 to 0.08 in the stretch range of 0.1% to 30%.

Therefore, according to the present invention, the first and second composite substrates DEEC-$BaTiO_3$ and DEEC-$SrTiO_3$ may have excellent frequency characteristics when first and second composite substrates DEEC-$BaTiO_3$ and DEEC-$SrTiO_3$ are applied to the antenna 200 as described above.

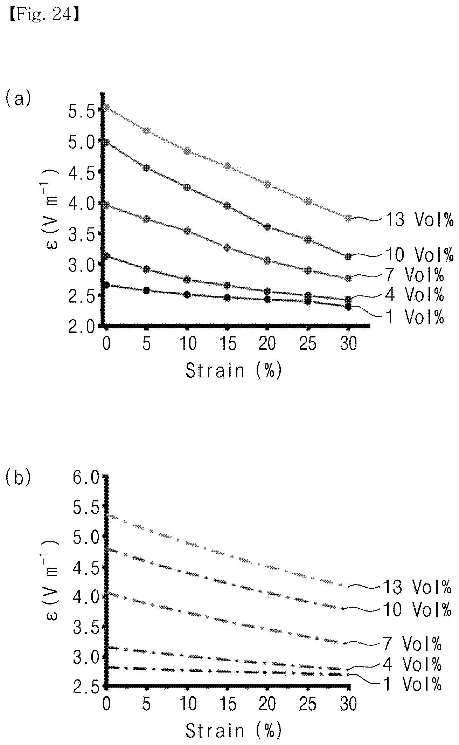

FIGS. 24(a) and 24(b) are results of stretching the first composite substrate 100 according to the experimental example of the present invention in a stretch range of 0.1% to 30% when a volume ratio occupied by the dielectric powder 3 is 1% to 13 (1 to 13 vol%).

Referring to FIGS. 24(a) and 24(b), it can be seen that the dielectric constant of the first composite substrate 100 rapidly decreases as the volume ratio occupied by the dielectric powder 3 increases.

Meanwhile, when the volume ratio occupied by the dielectric powder 3 is greater than 7% and equal to or less than 13% it can be seen that the dielectric constant of the first composite substrate 100 is maintained with a gradient in a range of 0.058 to 0.059.

Accordingly, according to the experimental example of the present invention, it may be proved that the first composite substrate 100 includes the dielectric powder 3 in the volume ratio of greater than 7% and equal to or less than 13% in consideration of a relationship between the stretched length, the dielectric constant, and the frequency as described above, thereby improving frequency characteristics of the antenna 200.

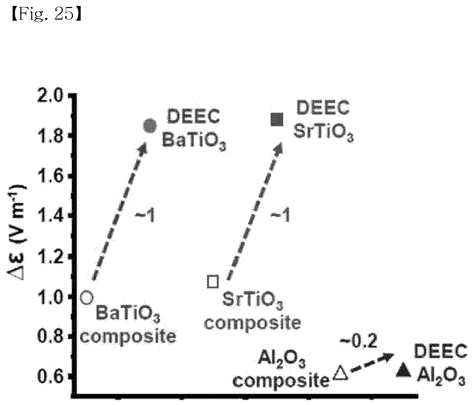

FIG. 25 is a result of measuring dielectric constants of the first composite substrate DEEC-$BaTiO_3$ according to the experimental example of the present invention, the second composite substrate DEEC-$SrTiO_3$ according to the experimental example of the present invention, and the third composite substrate DEEC-$Al_2O_3$ according to the experimental example of the present invention.

Referring to FIG. 25, through the experiment of the present invention, it can be seen that when barium titanate ($BaTiO_3$) and strontium titanate ($SrTiO_3$) are used as the dielectric powder 3, dielectric constant change characteristics are superior to those when aluminum oxide ($Al_2O_3$) is used.

FIG. 26 is a result of measuring a relationship between a strain at break and an initial dielectric constant of the first composite substrate 100 according to the experimental example of the present invention according to the volume ratio occupied by the dielectric powder 3.

Referring to FIG. 26, it can be seen that as the volume ratio occupied by the dielectric powder 30 increases, the strain at break of the first composite substrate 100 decreases, but the initial dielectric constant thereof increases.

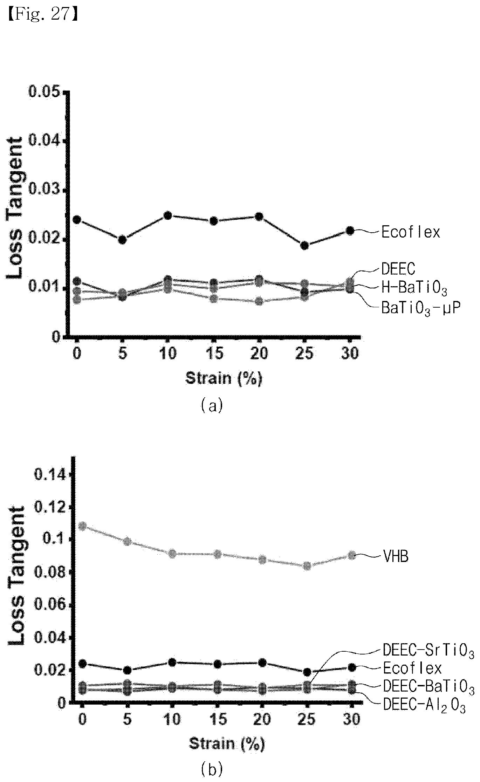

FIG. 27(a) is a result of measuring dielectric losses (Loss Tangent) of the first composite substrate DEEC according to the experimental example of the present invention, the first substrate $BaTiO_3$-$\mu$P according to the comparative example, the second substrate H-$BaTiO_3$ according to the comparative example, and the first stretchable polymer Ecoflex according to the comparative example, in a stretch (strain) range of 0.1% to 30%.

Referring to FIG. 27(a), the dielectric loss of the first composite substrate DEEC is less than that of other comparative examples, and it can be seen that the dielectric loss is maintained constant even when the first composite substrate DEEC is stretched in the stretch range of 0.1% to 30%.

Accordingly, excellent dielectric constant characteristics of the composite substrate 100 manufactured according to the experimental example of the present invention may be proved.

FIG. 27(b) is a result of measuring dielectric losses (Loss Tangent) of the first composite substrate DEEC-$BaTiO_3$ according to the experimental example of the present invention, the second composite substrate DEEC-$SrTiO_3$ according to the experimental example of the present invention, the third composite substrate DEEC-$Al_2O_3$ according to the experimental example of the present invention, the first stretchable polymer Ecoflex according to the comparative example, and the second stretchable polymer VHB according to the comparative example, in a stretch (strain) range of 0.1% to 30%.

Referring to FIG. 27(b), it can be seen that the dielectric losses of the first to third composite substrates DEEC-

BaTiO$_3$, DEEC-SrTiO$_3$, and DEEC-Al$_2$O$_3$ are similar, but are less than that of other comparative examples, and the dielectric losses are maintained constant even when the first to third composite substrates DEEC-BaTiO$_3$, DEEC-SrTiO$_3$, and DEEC-Al$_2$O$_3$ are stretched in the stretch range of 0.1% to 30%.

Accordingly, excellent dielectric constant characteristics of the composite substrate 100 manufactured according to the experimental example of the present invention may be proved.

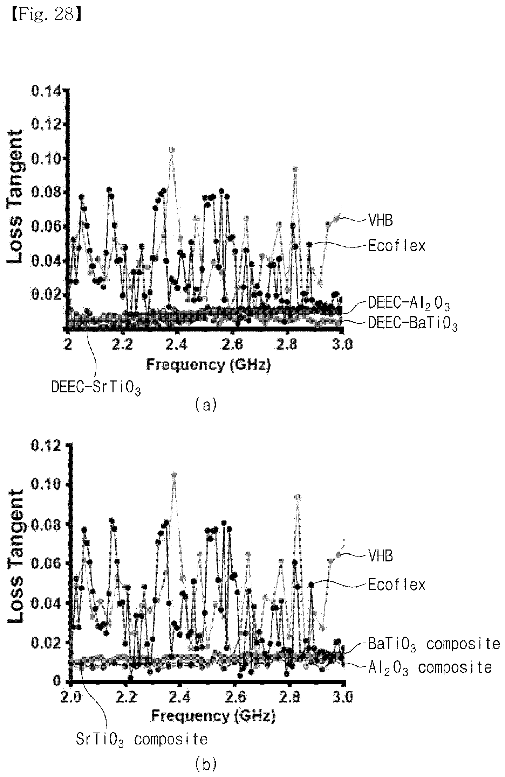

FIG. 28(a) is a result of measuring dielectric losses (Loss Tangent) of the second substrate BaTiO$_3$-composite according to the comparative example, the third substrate SrTiO$_3$-composite according to the comparative example, the fourth substrate Al$_2$O$_3$-composite according to the comparative example, the first stretchable polymer Ecoflex according to the comparative example, and the second stretchable polymer VHB according to the comparative example, in a frequency range of 2.0 to 3.0.

Referring to FIG. 28(a), among the comparative examples, when barium titanate (BaTiO$_3$), strontium titanate (SrTiO$_3$), and aluminum oxide (Al$_2$O$_3$) are included as the dielectric powder 3, it can be seen that the dielectric loss is small and is maintained relatively constant in a frequency range of 2.0 to 3.0.

On the other hand, among the comparative examples, in a case where the dielectric powder 3 is not included, that is, in a case of being formed of only the stretchable polymer materials Ecoflex and VHB, it can be seen that the dielectric loss is large and irregularly increased and decreased in the frequency range of 2.0 to 3.0.

FIG. 28(b) is a result of measuring dielectric losses (Loss Tangent) of the first composite substrate DEEC-BaTiO$_3$ according to the experimental example of the present invention, the second composite substrate DEEC-SrTiO$_3$ according to the experimental example of the present invention, the third composite substrate DEEC-Al$_2$O$_3$ according to the experimental example of the present invention, the first stretchable polymer Ecoflex according to the comparative example, and the second stretchable polymer VHB according to the comparative example, in a frequency range of 2.0 to 3.0.

Referring to FIG. 28(b), when barium titanate (BaTiO$_3$), strontium titanate (SrTiO$_3$), and aluminum oxide (Al$_2$O$_3$) are included as the dielectric powder 3 according to the experimental example of the present invention, it can be seen that the dielectric loss is small and is maintained constant in the frequency range of 2.0 to 3.0 as compared to the second substrate BaTiO$_3$-composite according to the comparative example, the third substrate SrTiO$_3$-composite according to the comparative example, and the fourth substrate Al$_2$O$_3$-composite according to the comparative example.

Thus, according to the experimental example of the present invention, when water is provided as the catalyst 4, since the dielectric cluster 30 is formed, it may be proved that the manufactured composite substrate 100 has excellent dielectric constant characteristics.

On the other hand, as described above, among the comparative examples, in a case where the dielectric powder 3 is not included, that is, in a case of being formed of only the stretchable polymer materials Ecoflex and VHB, it can be seen that the dielectric loss is large and irregularly increased and decreased in the frequency range of 2.0 to 3.0.

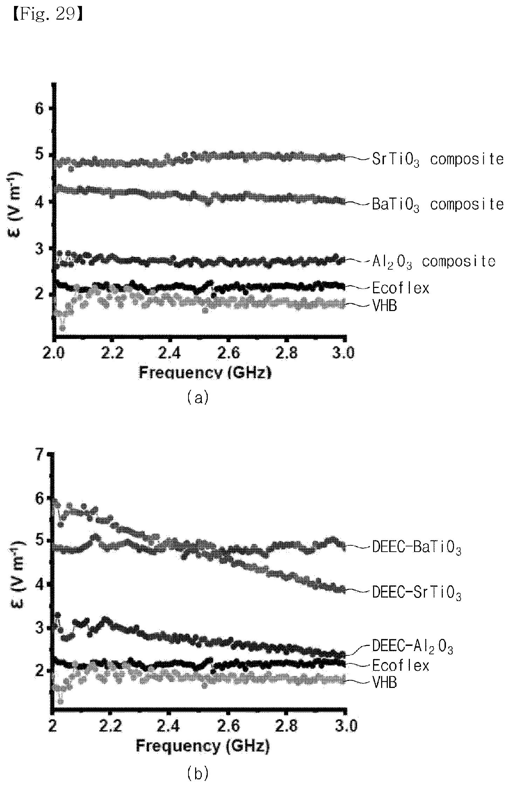

FIG. 29(a) is a result of measuring dielectric constants of the second substrate BaTiO$_3$-composite according to the comparative example, the third substrate SrTiO$_3$-composite according to the comparative example, the fourth substrate Al$_2$O$_3$-composite according to the comparative example, the first stretchable polymer Ecoflex according to the comparative example, and the second stretchable polymer VHB according to the comparative example, in a frequency range of 2.0 to 3.0.

Referring to FIG. 29(a), among the comparative examples, when barium titanate (BaTiO$_3$), strontium titanate (SrTiO$_3$), and aluminum oxide (Al$_2$O$_3$) are included as the dielectric powder 3, it can be seen that the dielectric constant is high and is maintained relatively constant as compared to other comparative examples (Ecoflex and VHB) in the frequency range of 2.0 to 3.0.

FIG. 29(b) is a result of measuring dielectric constants of the first composite substrate DEEC-BaTiO$_3$ according to the experimental example of the present invention, the second composite substrate DEEC-SrTiO$_3$ according to the experimental example of the present invention, the third composite substrate DEEC-Al$_2$O$_3$ according to the experimental example of the present invention, the first stretchable polymer Ecoflex according to the comparative example, and the second stretchable polymer VHB according to the comparative example, in a frequency range of 2.0 to 3.0.

Referring to FIG. 29(b), when barium titanate (BaTiO$_3$) and strontium titanate (SrTiO$_3$) are included as the dielectric powder 3 according to the experimental example of the present invention, it can be seen that the dielectric loss is high in the frequency range of 2.0 to 3.0 as compared to the comparative examples described above, that is, the second substrate BaTiO$_3$-composite according to the comparative example and the third substrate SrTiO$_3$-composite according to the comparative example.

Thus, according to the experimental example of the present invention, when water is provided as the catalyst 4, since the dielectric cluster 30 is formed, it may be proved that the manufactured composite substrate 100 has excellent dielectric constant characteristics.

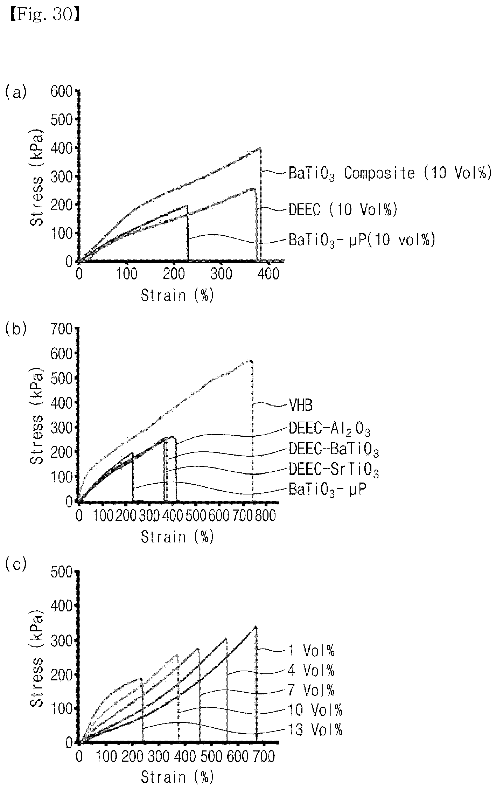

FIG. 30(a) is a result of measuring strains according to the applied stress in the first composite substrate DEEC according to the experimental example of the present invention, the first substrate BaTiO$_3$-$\mu$P according to the comparative example, and the second substrate BaTiO$_3$-composite according to the comparative example, when a volume ratio occupied by the dielectric powder 3 is 10% (10 vol%).

Referring to FIG. 30(a), it can be seen that the maximum strains of the first composite substrate DEEC and the second substrate $BaTiO_3$-composite according to the stress are similar, whereas the maximum strain of the first substrate $BaTiO_3$-$\mu$P according to the stress is about half of that of the first composite substrate DEEC and the second substrate $BaTiO_3$-composite.

Therefore, according to the experimental example of the present invention, when the dielectric cluster 30 is included, as described above, it can be seen that not only the dielectric constant is excellent, but also the strain according to the applied stress has a level similar to that of the substrate (the second substrate $BaTiO_3$-composite) including the nanoparticle-sized dielectric powder 3.

On the other hand, it can be seen that the strain according to the applied stress is weak in the first substrate $BaTiO_3$-$\mu$P including the dielectric powder 30 in a micro size.

Accordingly, according to the experimental example of the present invention, excellent elasticity of the first composite substrates 100 and DEEC may be proved.

FIG. 30(b) is a result of measuring strains of the first composite substrate DEEC-$BaTiO_3$ according to the experimental example of the present invention, the second composite substrate DEEC-$SrTiO_3$ according to the experimental example of the present invention, the third composite substrate DEEC-$Al_2O_3$ according to the experimental example of the present invention, the first substrate $BaTiO_3$-$\mu$P according to the comparative example, and the second stretchable polymer VHB according to the comparative example, according to the applied stress.

Referring to FIG. 30(b), it can be seen that the maximum strains according to the stress of the first to third composite substrates DEEC-$BaTiO_3$, DEEC-$SrTiO_3$, and DEEC-$Al_2O_3$ are similar, but are superior to the maximum strain according to the stress of the first substrate $BaTiO_3$-$\mu$P.

Thus, according to the experimental example of the present invention, when barium titanate ($BaTiO_3$), strontium titanate ($SrTiO_3$), and aluminum oxide ($Al_2O_3$) are included as the dielectric powder 3, it can be seen that, as described above, not only the dielectric constant is excellent, but also the strain according to the applied stress is excellent due to the dielectric cluster 30 manufactured from the dielectric powder 3.

Therefore, according to the experimental example of the present invention, excellent elasticity of the first composite substrate 100 may be proved.

FIG. 30(c) is a result of measuring a strain of the first composite substrate 100 according to the experimental example of the present invention according to the applied stress, when a volume ratio occupied by the dielectric powder 3 is 1% to 13% (1 to 13 vol%).

Referring to FIG. 30(c), it can be seen that as the volume ratio occupied by the dielectric powder 3 increases, the maximum strain of the first composite substrate 100 according to the stress decreases.

This may be because as the volume ratio of the first composite substrate 100, which is occupied by the dielectric powder 3, increases, the volume ratio of the first composite substrate 100, which is occupied by the stretchable polymer 1, relatively decreases.

However, according to the experimental example of the present invention, even when the volume ratio of the first composite substrate 100, which is occupied by the dielectric powder 3, increases to 1% to 13% (1 to 13 vol%), it can be seen that the maximum strain of the first composite substrate 100 according to the stress is superior to the maximum strain of the first substrate $BaTiO_3$-$\mu$P according to the stress described above.

Therefore, according to the experimental example of the present invention, excellent elasticity of the first composite substrate 100 may be proved.

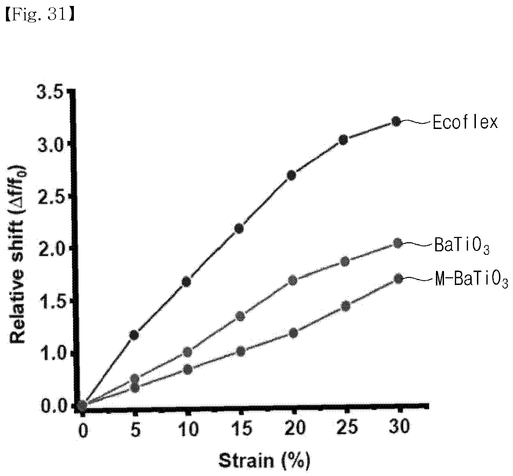

FIG. 31 is a result of measuring frequency shifts ($\Delta f/f_0$) of the first composite substrate M-$BaTiO_3$ according to the experimental example of the present invention, the second substrate $BaTiO_3$ according to the comparative example, and the first stretchable polymer Ecoflex according to the comparative example, in a stretch (strain) range of 0.1% to 30%.

Referring to FIG. 31, it can be seen that the composite substrate (the first composite substrate M-$BaTiO_3$) according to the experimental example of the present invention has the lowest frequency shift in the stretch range of 0.1% to 30%.

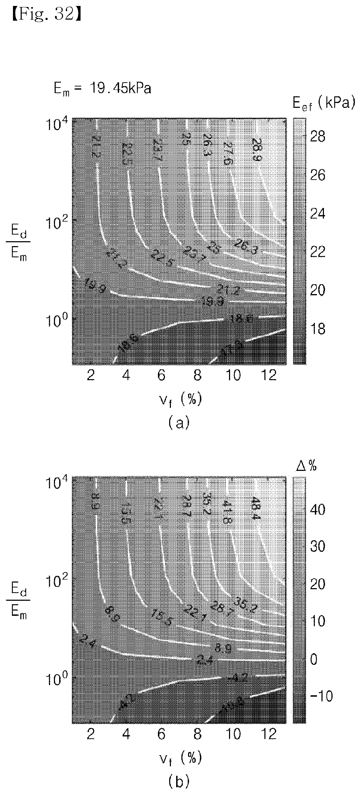

FIGS. 32(a) to 33(f) are simulation results of the first composite substrate 100 according to the experimental example of the present invention according to the application of stress of 19.45 kPa, when the volume ratio occupied by the dielectric powder 3 is 1% to 13% (1 to 13 vol%).

Referring to FIGS. 32(a) to 33(f), it can be seen that as the volume ratio of the first composite substrate 100, which is occupied by the dielectric powder 3, increases, the stress per unit volume increases.

FIG. 34 is a result of measuring thermal conductivities of the first composite substrate DEEC according to the experimental example of the present invention, the first substrate $BaTiO_3$-$\mu$P according to the comparative example, the first stretchable polymer Ecoflex according to the comparative example, and the second stretchable polymer VHB according to the comparative example.

Referring to FIG. 34, the first composite substrate DEEC may have a thermal conductivity of 0.1 W/mk to 10 W/mk.

This may be because, according to the experimental example of the present invention, the composite substrate 100 includes the dielectric powder 3, as described above.

Accordingly, according to the present invention, as described above, when the composite substrate 100 is applied to the antenna 200, the composite substrate 100 may have excellent thermal conductivity characteristics.

FIG. 35 is a result of measuring a change in dielectric constant ($\triangle\varepsilon$), a dielectric loss (Loss Tangent), elasticity (Stretchability), a thermal conductivity (k), and a Young's modulus of the first composite substrate DEEC according to the experimental example of the present invention, the first substrate $BaTiO_3$-$\mu$P according to the comparative example, the second substrate H-$BaTiO_3$ according to the comparative example, and the first stretchable polymer Ecoflex according to the comparative example.

Referring to FIG. 35, it can be seen that the first composite substrate DEEC has balanced and excellent change in dielectric constant, dielectric loss, elasticity, thermal conductivity, and Young's modulus.

Accordingly, according to the experimental example of the present invention, it may be proved that the first composite substrates 100 and DEEC may be applied to the antenna 200 of a flexible system.

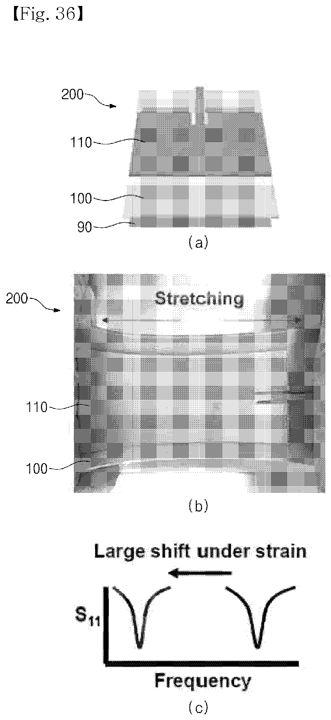

FIG. 36(a) is an experimental conceptual view of the antenna 200 according to the experimental example of the present invention, FIG. 36(b) is a photograph of an experimental setting of the antenna 200 according to the experimental example of the present invention, and FIGS. 36(b) and 36(c) are conceptual views of frequency characteristics when stretching is performed in a typical antenna.

Referring to FIG. 36(a), in order to manufacture the antenna 200, as described above, the ground panel 90 may be formed on the lower surface of the first composite substrate 100, and the patch 110 may be formed on the upper surface of the first composite substrate 100.

Meanwhile, referring to FIG. 36(b), the antenna 200 manufactured according to the above-described experimental conceptual view of FIG. 36(a) may be observed. As described above, it can be seen that the manufactured antenna 200 has excellent stretching characteristics because the first composite substrate 100 has elasticity.

Meanwhile, the above-described experiments according to FIGS. 36(a) and 36(b) are applied not only to the embodiment of the present invention but also to the comparative examples described above. In other words, in the above-described experiments according to FIGS. 36(a) and 36(b), the above-described experimental examples and comparative examples of the present invention are applied to the substrate.

Meanwhile, referring to FIG. 36(c), as described above, in a case where an antenna including a typical dielectric as a substrate, when the antenna is stretched, the dielectric constant may change.

However, according to the present invention, the antenna 200 may maintain a constant frequency when the antenna 200 is stretched.

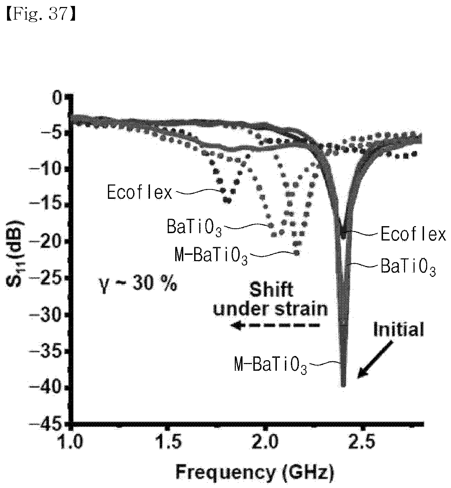

FIG. 37 is a result of simulating frequency characteristics of the antenna M-$BaTiO_3$ according to the experimental example of the present invention, the first antenna Ecoflex according to the comparative example, and the second antenna $BaTiO_3$ according to the comparative example when the antenna M-$BaTiO_3$, the first antenna Ecoflex, and the second antenna $BaTiO_3$ are stretched.

Referring to FIG. 37, as the simulation result, it is predicted that the frequency shift of the antenna M-$BaTiO_3$ may be the least when the antenna M-$BaTiO_3$, the first antenna Ecoflex, and the second antenna $BaTiO_3$ are stretched.

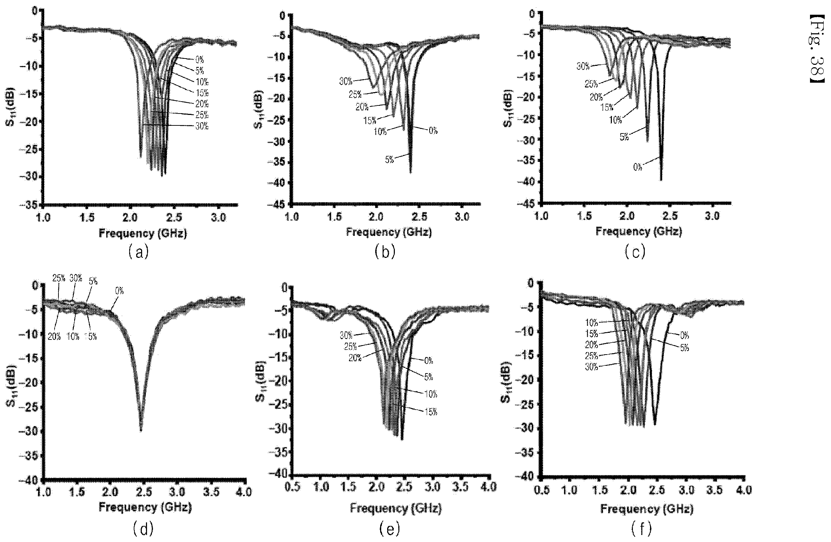

FIG. 38(a) is a result of simulating frequency characteristics when the antenna M-$BaTiO_3$ according to the experimental example of the present invention is stretched in a stretch range of 0.1% to 30%, FIG. 38(b) is a result of simulating frequency characteristics when the second antenna $BaTiO_3$ according to the comparative example is stretched in a stretch range of 0.1% to 30%, and FIG. 38(c) is a result of simulating frequency characteristics when the first antenna Ecoflex according to the comparative example is stretched in a stretch range of 0.1% to 30%.

FIG. 38(d) is a result of measuring frequency characteristics by detuning a resonance frequency when the antenna M-$BaTiO_3$ according to the experimental example of the present invention is stretched in a stretch range of 0.1% to 30%, FIG. 38(e) is a result of measuring frequency characteristics by detuning a resonance frequency when the second antenna $BaTiO_3$ according to the comparative example is stretched in a stretch range of 0.1% to 30%, and FIG. 38(f) is a result of measuring frequency characteristics by detuning a resonance frequency when the first antenna Ecoflex according to the comparative example is stretched in a stretch range of 0.1% to 30%.

Referring to FIGS. 38(a) to 38(f), unlike other comparative examples, it can be seen that the antenna M-$BaTiO_3$ maintains a constant frequency of 2.5 GHz without a change in frequency even when the antenna M-$BaTiO_3$ is stretched in the stretch range of 0.1% to 30% (see FIG. 38(d)).

Accordingly, according to the experimental example of the present invention, the antenna M-$BaTiO_3$ may maintain a constant frequency, and thus excellent frequency characteristics thereof may be proved.

This may be because, as described above, the composite substrates 100 and M-$BaTiO_3$ of the antennas 200 and M-$BaTiO_3$ may include the dielectric cluster 30, and when the composite substrates 100 and M-$BaTiO_3$ are stretched in an elongation direction, the shape of the dielectric cluster 30 may be changed so that the dielectric constant may substantially decrease linearly and rapidly.

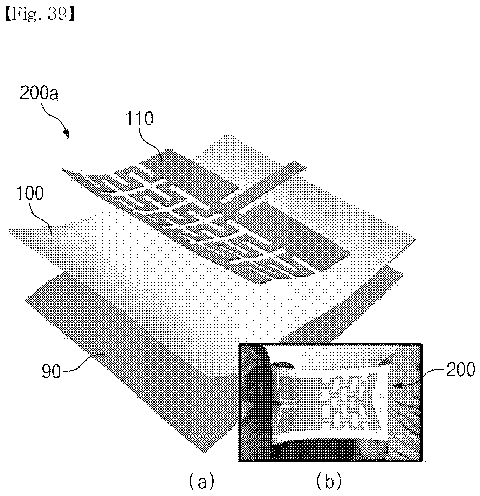

FIG. 39(a) is a schematic view of a first antenna 200a in which a pattern of the patch 110 is formed in a first shape according to the experimental example of the present invention, and FIG. 39(b) is a photograph of the first antenna 200a in which the pattern of the patch 110 is formed in the first shape according to the experimental example of the present invention.

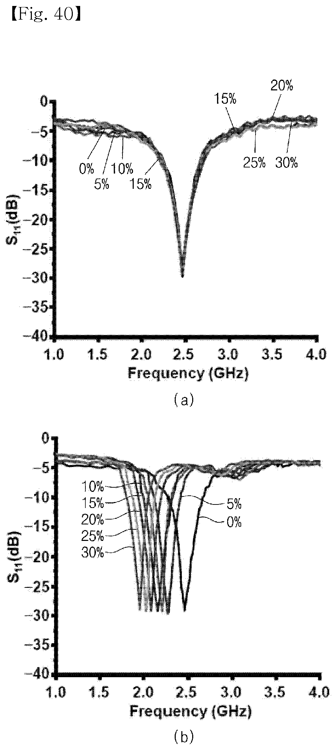

FIG. 40(a) is a result of measuring a frequency when the first antenna 200a according to the experimental example of the present invention is stretched in a stretch range of 0.1% to 30%, and FIG. 40(b) is a result of measuring a frequency when the first antenna Ecoflex according to the comparative example is stretched in a stretch range of 0.1% to 30%.

Referring to FIG. 40(a), unlike the comparative example shown in FIG. 40(b), it can be seen that the first antenna 200a maintains a constant frequency of 2.5 GHz without a change in frequency even when the first antenna 200a is stretched in the stretch range of 0.1% to 30%.

Accordingly, according to the experimental example of the present invention, the first antenna 200a may maintain a constant frequency, and thus excellent frequency characteristics thereof may be proved.

This may be because, as described above, the composite substrate 100 of the antenna 200 may include the dielectric cluster 30, and when the composite substrate 100 is stretched in an elongation direction, the shape of the dielectric cluster 30 may be changed so that the dielectric constant may substantially decrease linearly and rapidly.

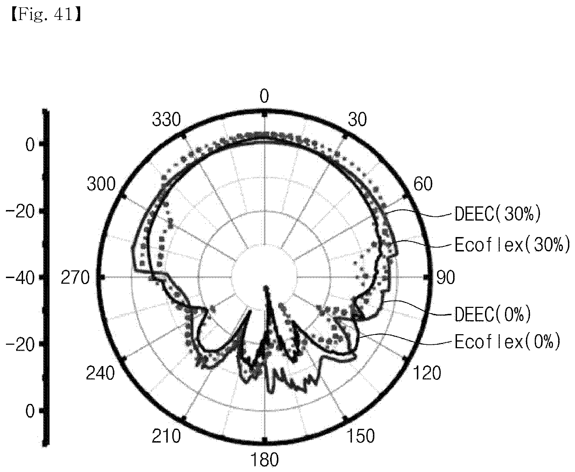

FIG. 41 is a power distribution view of the first antennas DEEC and 200a according to the experimental example of the present invention and the first antenna Ecoflex according to the comparative example before stretching and after stretched by 30%.

Referring to FIG. 41, it can be seen that the peak values of the first antenna Ecoflex are 1.41 dBi and 1.43 dBi before stretching and after stretched by 30%, respectively, whereas the peak values of the first antennas DEEC and 200a are 2.96 dBi and 1.43 dBi before stretching and after stretched by 30%, respectively.

Thus, according to the experimental example of the present invention, it may be proved that a conductive region increases as compared to the comparative example (Ecoflex) when the first antennas DEEC and 200a are stretched.

FIG. 39(a) is a schematic view of a second antenna 200b in which the pattern of the patch 110 is formed in a second shape according to the experimental example of the present invention, and FIG. 39(b) is a photograph of the second antenna 200b in which the pattern of the patch 110 is formed in the second shape according to the experimental example of the present invention.

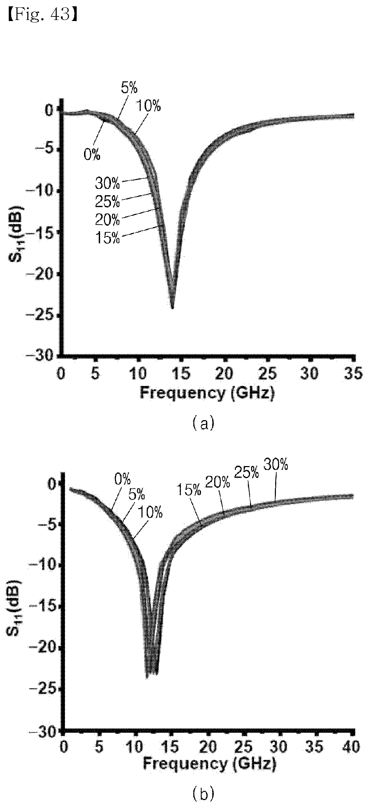

FIG. 43(a) is a result of measuring a frequency when the second antenna 200b according to the experimental example of the present invention is stretched in a stretch range of 0.1% to 30%, and FIG. 43(b) is a result of measuring a frequency when the first antenna Ecoflex according to the comparative example is stretched in a stretch range of 0.1% to 30%.

Referring to FIG. 43(a), unlike the comparative example shown in FIG. 43(b), it can be seen that the second antenna 200b maintains a constant frequency of 14 GHz without a change in frequency even when the first antenna 200a is stretched in the stretch range of 0.1% to 30%.

Accordingly, according to the experimental example of the present invention, the second antenna 200b may maintain a constant frequency, and thus excellent frequency characteristics thereof may be proved.

This may be because, as described above, the composite substrate 100 of the antenna 200 may include the dielectric cluster 30, and when the composite substrate 100 is stretched in an elongation direction, the shape of the dielectric cluster 30 may be changed so that the dielectric constant may substantially decrease linearly and rapidly.

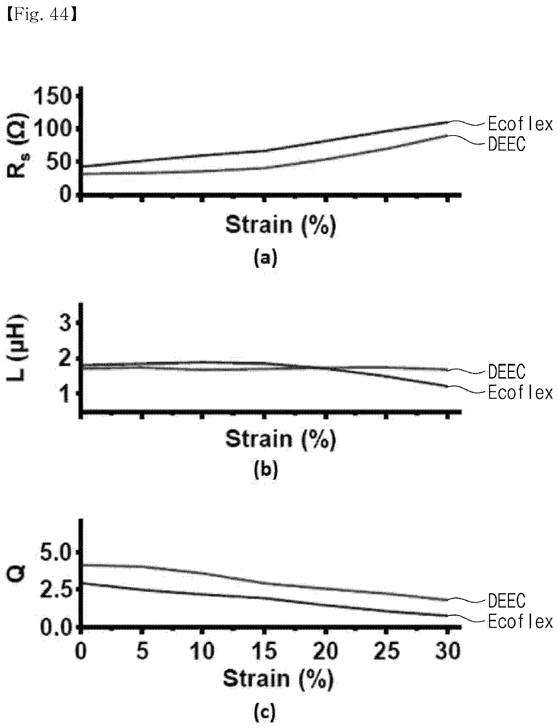

FIG. 44(a) is a resistance $R_s$ before and after stretching of the second antennas DEEC and 200b according to the experimental example of the present invention and the first antenna Ecoflex according to the comparative example, FIG. 44(b) is an inductance L before and after stretching of the second antennas DEEC and 200b according to the experimental example of the present invention and the first antenna Ecoflex according to the comparative example, and FIG. 44(c) is a quality factor Q before and after stretching of the second antennas DEEC and 200b according to the experimental example of the present invention and the first antenna Ecoflex according to the comparative example.

Referring to FIG. 44(a), it can be seen that the resistance increases in all the second antennas DEEC and 200b and the first antenna Ecoflex according to stretching, but the resistance of the second antennas DEEC and 200b is smaller than the resistance of the first antenna Ecoflex because the dielectric loss (Loss Tangent) is low in the second antennas DEEC and 200b as described above.

Meanwhile, referring to FIG. 44(b), it can be seen that the inductance of the first antenna Ecoflex decreases according to stretching, but the inductance of the second antennas DEEC and 200b is maintained even when the second antennas DEEC and 200b are stretched.

Meanwhile, referring to FIG. 44(c), it can be seen that the quality factor is lowered according to stretching in all the second antennas DEEC and 200b and the first antenna Ecoflex, but the quality factor of the second antennas DEEC and 200b is higher than that of the first antenna Ecoflex.

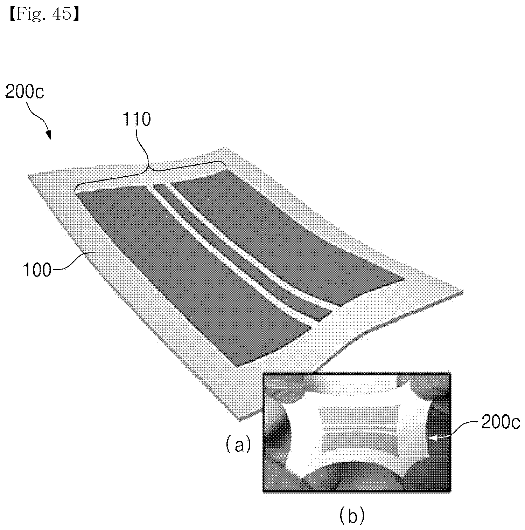

FIG. 45(a) is a schematic view of a third antenna 200c in which the pattern of the patch 110 is formed in a third shape according to the experimental example of the present invention, and FIG. 39(b) is a photograph of the third antenna 200c in which the pattern of the patch 110 is formed in the third shape according to the experimental example of the present invention.

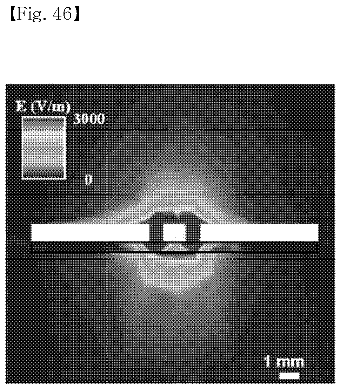

FIG. 46 shows a distribution of electric fields transmittable in a stretched state of the third antenna 200c according to the experimental example of the present invention.

Referring to FIG. 46, it can be seen that the third antenna 200c has excellent electric field characteristics even in the stretched state.

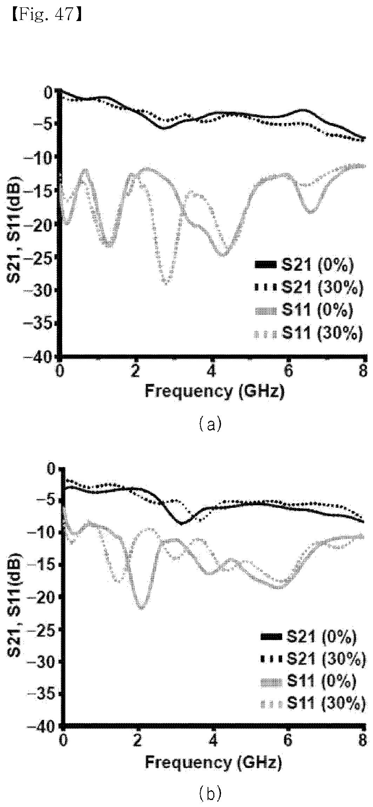

FIG. 47(a) is a result of measuring a frequency when the third antenna 200c according to the experimental example of the present invention is stretched by 30%, and FIG. 47(b) is a result of measuring a frequency when the first antenna Ecoflex according to the comparative example is stretched by 30%.

Referring to FIG. 47(a), unlike the comparative example shown in FIG. 47(b), it can be seen that the third antenna 200c maintains a constant frequency when the third antenna 200c is stretched by 30%.

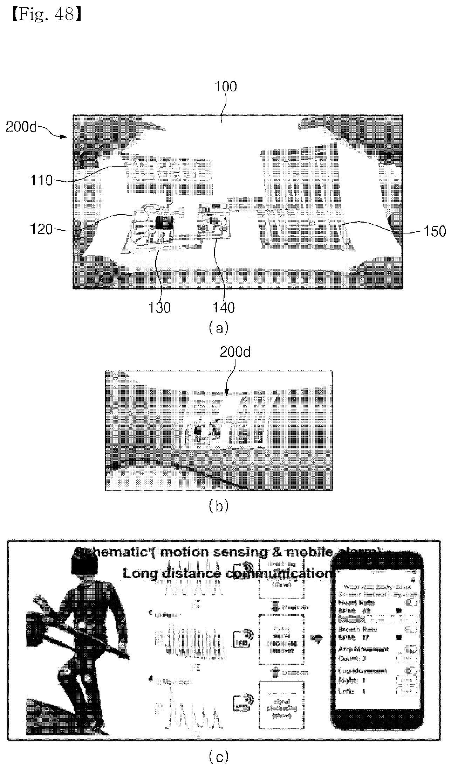

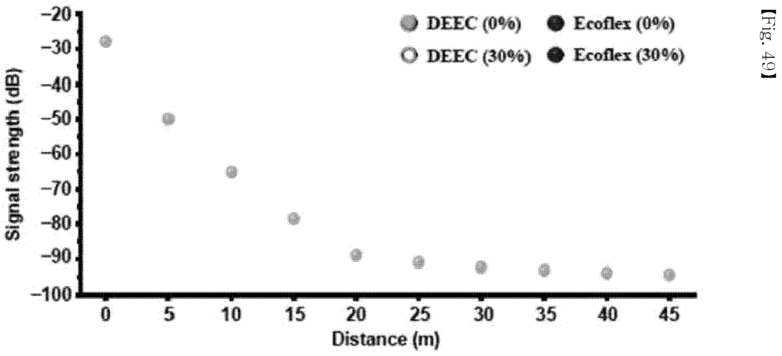

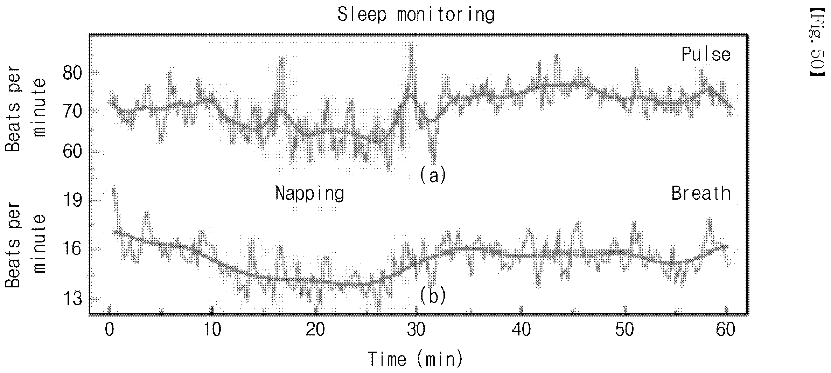

FIGS. 48(a) and 48(b) are photographs of a high-frequency device 200d according to the experimental example of the present invention, FIG. 48(c) shows a state in which the high-frequency device 200d is attached on a body, FIG. 49 is a result of measuring a signal for each distance by attaching the high-frequency device 200d to the body, and FIG. 50 is a result of monitoring sleep by attaching the high-frequency device 200d to the body.

Referring to FIGS. 48(a) to 48(c), the high-frequency device 200d may include at least one of the patch 110 (that is, an antenna patch), a Bluetooth low energy (BLE) circuit 120, a strain sensor 130, a rectifier circuit 140, and a near field communication (NFC) 150 on the complex substrate 100.

Referring to FIG. 49, it can be seen that the high-frequency device 200d has excellent signal characteristics even at a distance of 20 m.

In addition, referring to FIG. 50, it can be seen that the high-frequency device 200d may measure a pulse and breath during sleep.

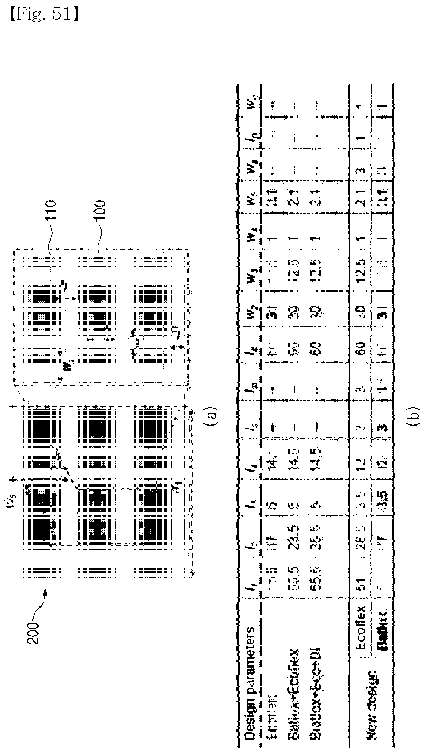

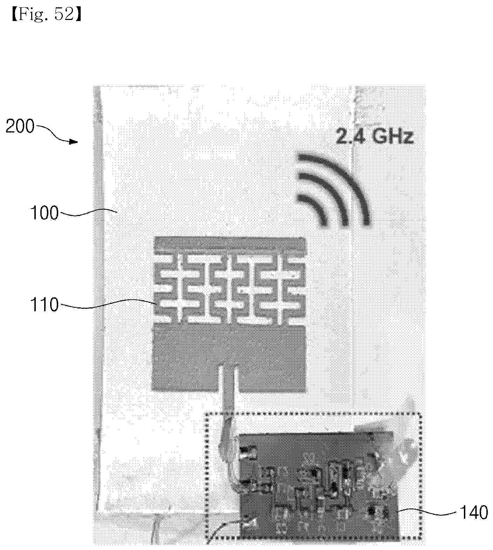

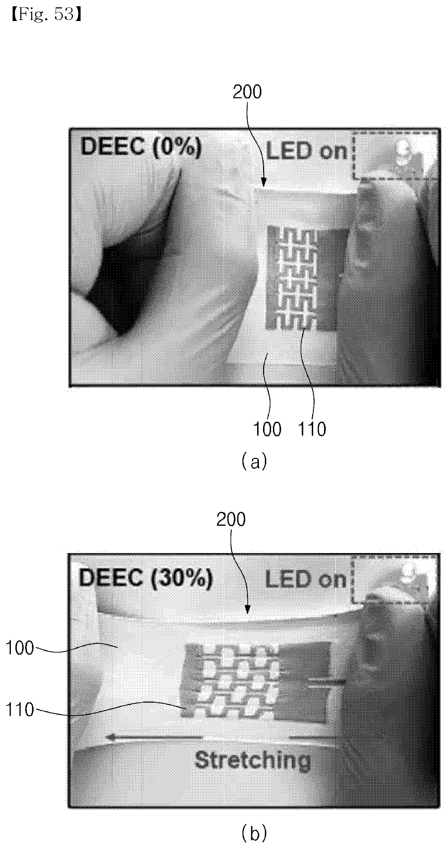

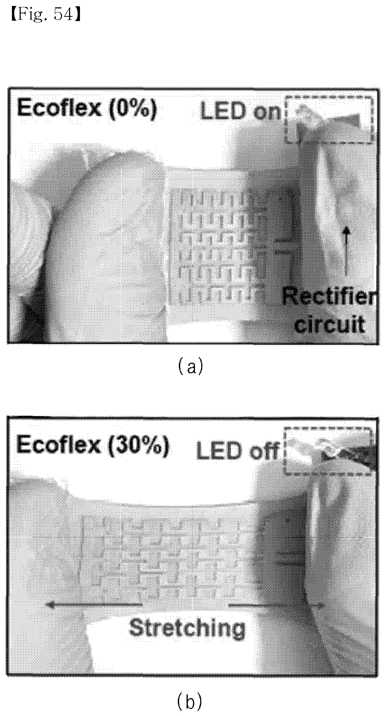

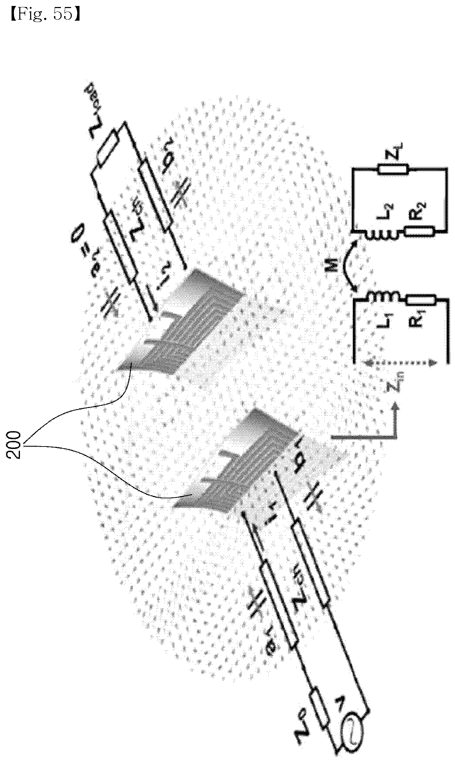

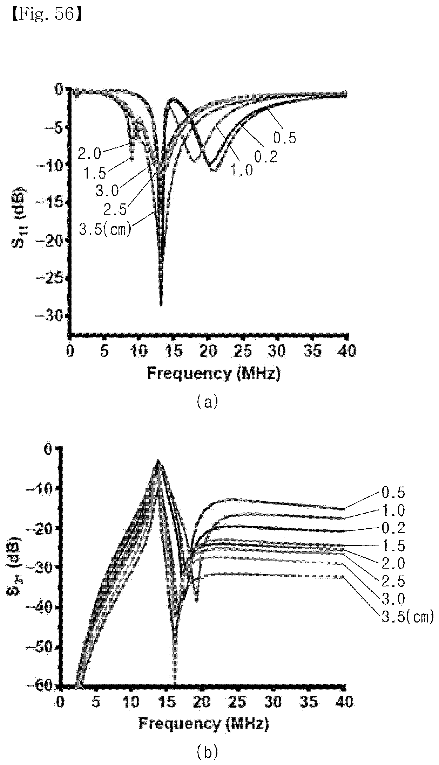

FIGS. 51(a) and 51(b) show specifications of the antenna 200 manufactured according to the experimental example of the present invention, FIG. 52 shows a photograph of the antenna 200 manufactured according to the specifications, FIGS. 53(a) and 53(b) show experimental photographs before and after 30% stretching of the antennas DEEC and 200, FIGS. 54(a) and 54(b) show experimental photographs before and after 30% stretching of the first antenna Ecoflex according to the comparative example, FIG. 55 shows a circuit view according to the experimental example of the present invention, and FIGS. 56(a) to 57(b) show power transmission efficiency of the antenna 200 in the circuit view.

Referring to FIGS. 56(a) to 57(a), it may be proved that the antenna 200 has excellent power transmission efficiency at a distance of 0.2 cm to 3.5 cm.

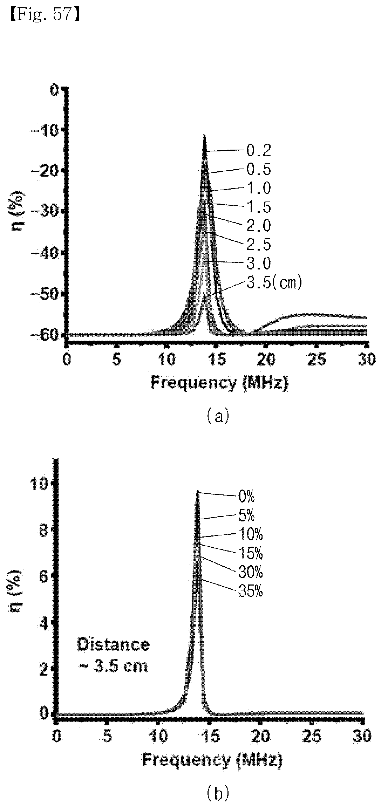

Meanwhile, referring to FIG. 57(b), it can be seen that the frequency of the antenna 200 is maintained constant without changing even when the antenna is stretched in a stretch range of 0.1% to 35% at a distance of 0.2 cm to 3.5 cm.

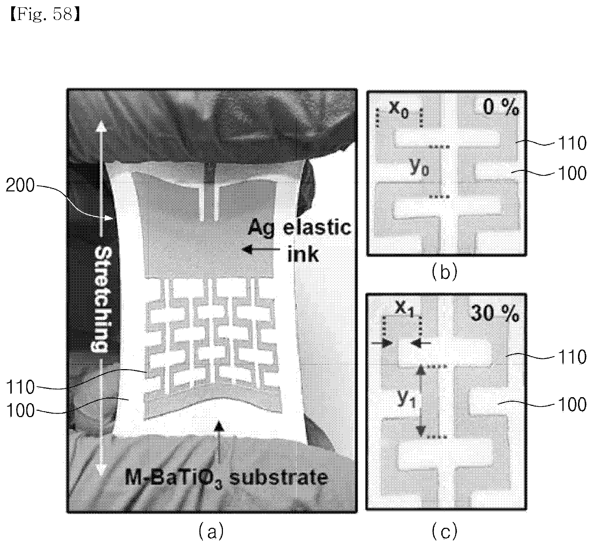

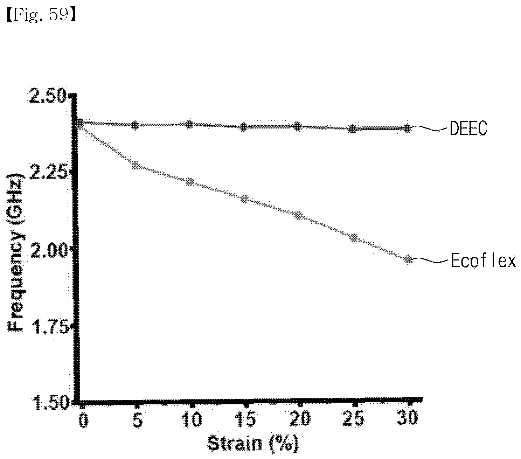

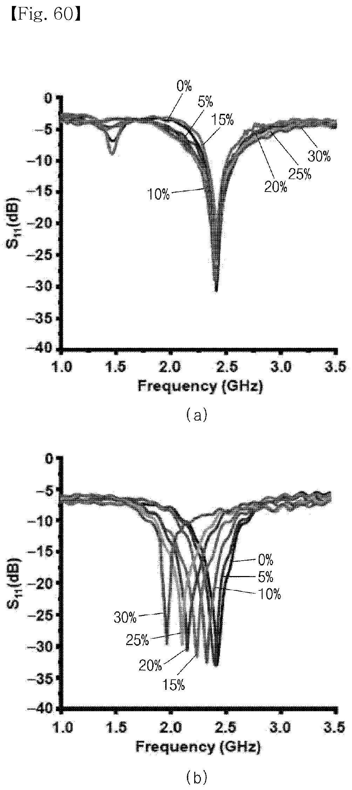

FIG. 58(a) is a photograph of the antenna 200 manufactured according to the experimental example of the present invention, FIG. 58(b) is a photograph before stretching of the antenna 200, FIG. 58(c) is a photograph after the antenna 200 is stretched by 30%, FIG. 59 is a result of measuring a frequency when the antenna 200 and the first antenna Ecoflex according to the comparative example are stretched in a stretch range of 0.1% to 30%, FIG. 60(a) is a result of measuring a frequency when the antenna 200 is stretched in a stretch range of 0.1% to 30%, and FIG. 60(b) is a result of measuring a frequency when the first antenna Ecoflex according to the comparative example is stretched in a stretch range of 0.1% to 30%.

Referring to FIGS. 59 to 60(b), unlike the comparative example, it can be seen that the antenna 200 maintains a constant frequency without changing even when the antenna 200 is stretched in the stretch range of 0.1% to 30%.

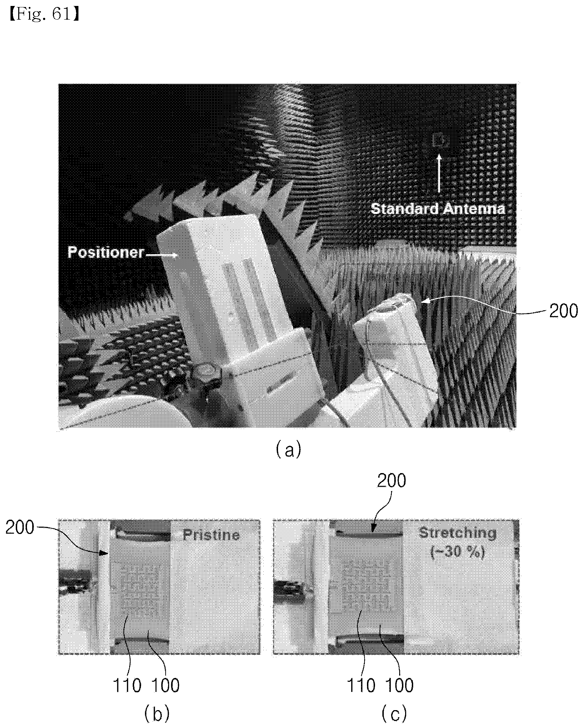

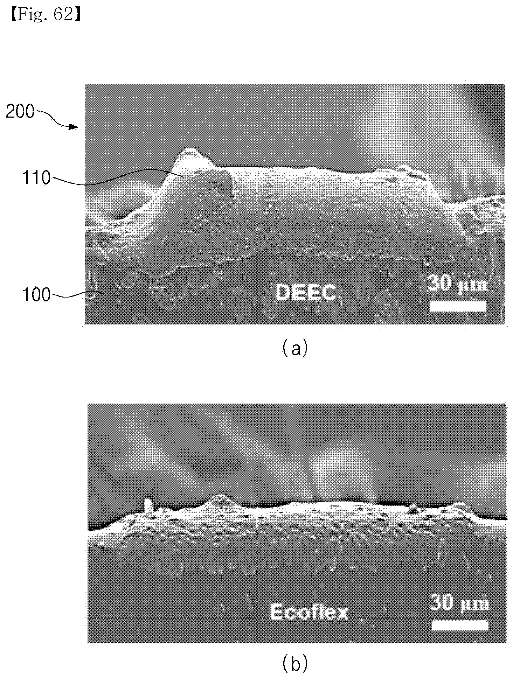

FIG. 61(a) is a photograph of the antenna 200 manufactured according to the experimental example of the present invention, FIG. 61(b) is a photograph before stretching of the antenna 200, FIG. 61(c) is a photograph after the antenna 200 is stretched by 30%, FIG. 62(a) is a photograph of a side of the antenna DEEC or 200, and FIG. 62(b) is a photograph of a side of the first antenna Ecoflex according to the comparative example.

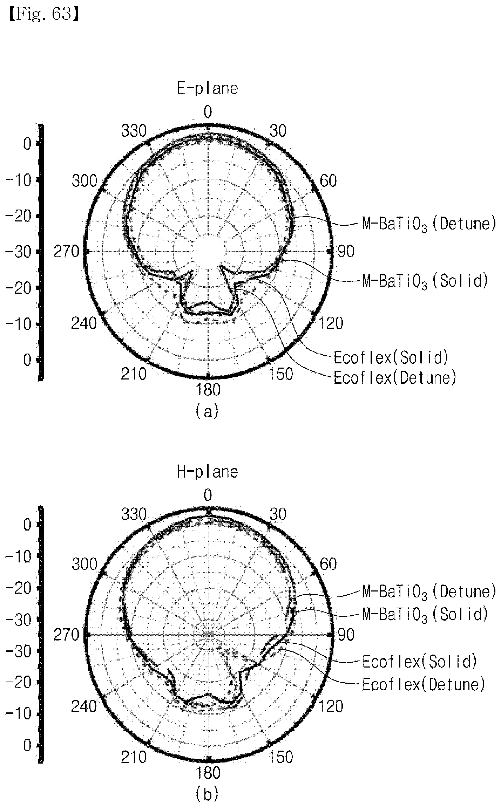

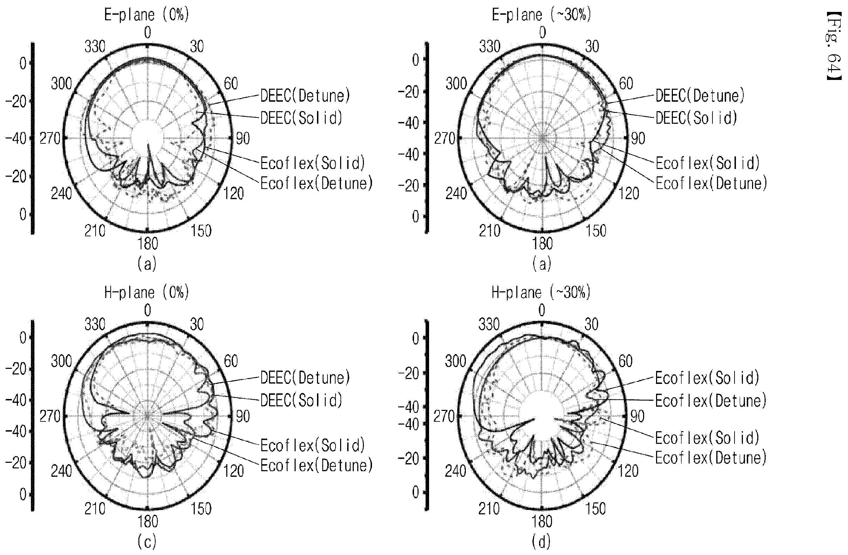

FIG. 63(a) is a E-plane power distribution view of the antennas $M-BaTiO_3$ and 200 manufactured according to the experimental example of the present invention and the first antenna Ecoflex according to the comparative example, FIG. 63(b) is a H-plane power distribution view of the antennas $M-BaTiO_3$ and 200 manufactured according to the experimental example of the present invention and the first antenna Ecoflex according to the comparative example, FIG. 64(a) is a E-plane power distribution view before the antennas $M-BaTiO_3$ and 200 manufactured according to the experimental example of the present invention and the first antenna Ecoflex according to the comparative example are stretched, FIG. 64(b) is a E-plane power distribution view after the antennas $M-BaTiO_3$ and 200 manufactured according to the experimental example of the present invention and the first antenna Ecoflex according to the comparative example are stretched by 30%, FIG. 64(c) is a H-plane power distribution view before the antennas $M-BaTiO_3$ and 200 manufactured according to the experimental example of the present invention and the first antenna Ecoflex according to the comparative example are stretched, and FIG. 64(d) is a H-plane power distribution view after the antennas $M-BaTiO_3$ and 200 manufactured according to the experimental example of the present invention and the first antenna Ecoflex according to the comparative example are stretched by 30%.

Referring to FIGS. 63(a) to 64(d), it can be seen that peak value characteristics of the antennas $M-BaTiO_3$ and

200 is superior to peak value characteristics of the first antenna Ecoflex.

Thus, according to the experimental example of the present invention, it may be proved that the conductive region increases as compared to the comparative example (Ecoflex) when the antennas M-BaTiO$_3$ and 200 are stretched.

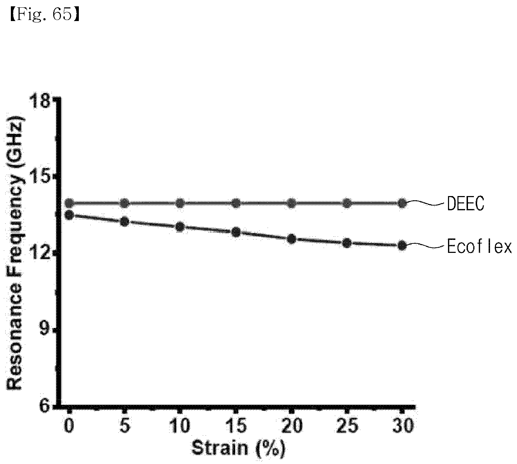

FIG. 65 is a result of measuring a frequency when the antennas DEEC and 200 manufactured according to the experimental example of the present invention and the first antenna Ecoflex according to the comparative example are stretched in a stretch range of 0.1% to 30%.

Referring to FIG. 65, unlike the comparative example, it can be seen that the frequencies of the antennas DEEC and 200 are maintained constant without changing even when the antennas DEEC and 200 are stretched in the stretch range of 0.1% to 30%.

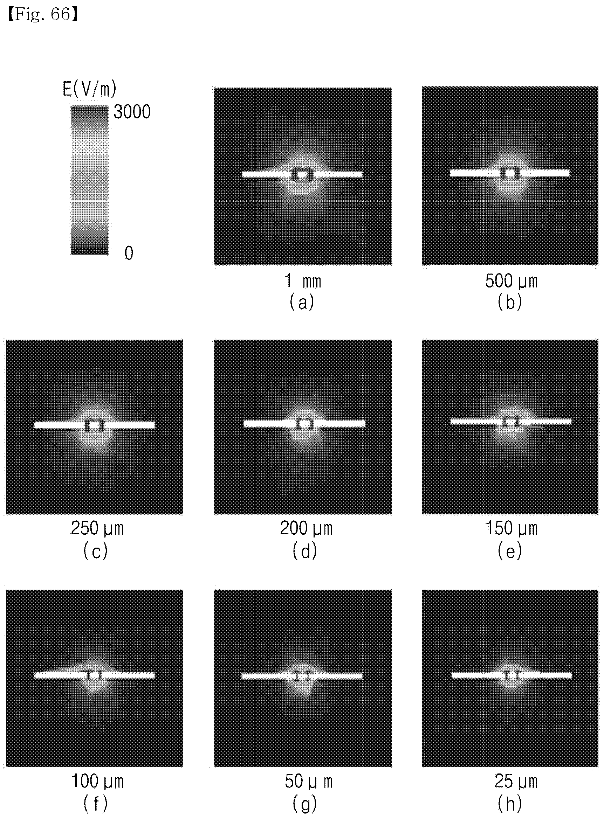

FIG. 66 shows a distribution of electric fields transmittable in a stretched state of the antenna 200 according to the experimental example of the present invention.

Referring to FIG. 66, it can be seen that the antenna 200 has excellent electric field characteristics even in the stretched state.

While the present invention has been described in connection with the embodiments, it is not to be limited thereto but will be defined by the appended claims. In addition, it is to be understood that those skilled in the art can substitute, change, or modify the embodiments in various forms without departing from the scope and spirit of the present invention.

**Claims**

1.  An antenna comprising:

    a composite substrate having elasticity and dielectric properties;
    a ground panel formed on a lower surface of the composite substrate and grounded; and
    a patch formed on an upper surface of the composite substrate and resonating at a frequency in a reference range,
    wherein when the composite substrate and the patch are stretched, a dielectric constant of the composite substrate is varied, and a frequency of the patch is maintained within the reference range.

2.  The antenna of claim 1, wherein at least one of the ground panel and the patch is formed of a metal conductor material having elasticity, and
    the metal conductor material having elasticity includes silver, copper, gold, or aluminum.

3.  The antenna of claim 1, wherein when the composite substrate and the patch are stretched, the dielectric constant is varied by a square of a stretched length, and
    the frequency is maintained within the reference range.

4.  The antenna of claim 1, wherein the composite substrate includes a dielectric cluster formed of dielectric powder and having a predetermined shape,

    when the antenna is stretched in a direction in which the composite substrate is stretched,
    the predetermined shape of the dielectric cluster is changed such that a number of the dielectric powder per unit volume of the composite substrate decreases, and
    the dielectric constant of the composite substrate decreases linearly.

5.  The antenna of claim 1, wherein the composite substrate has a variable dielectric constant range in a stretch range of 0.1% to 30%, and
    the variable dielectric range is 1.5 to 7.5.

6.  The antenna of claim 1, wherein the frequency of the patch is maintained within the reference range in a stretch range of 0.1% to 30%.

7.  The antenna of claim 1, wherein the composite substrate has a thermal conductivity of 0.1 W/mk to 10 W/mk.

8.  The antenna of claim 1, wherein the composite substrate includes a stretchable polymer matrix formed of a stretchable polymer having elasticity,

    the stretchable polymer is a silicon-based material, and

the silicon-based material includes at least one selected from materials including ecoflex, polydimethylsiloxane (PDMS), and styrene-ethylene-butylene-styrene (SEBS).

9. The antenna of claim 4, wherein the dielectric powder is a metal oxide-based material, and the dielectric powder is at least one selected from metal oxide-based materials including barium titanate, strontium titanate, and aluminum oxide.

10. A method for manufacturing an antenna, the method comprising:

preparing a composite substrate having elasticity and dielectric properties;
forming a ground panel on a lower surface of the composite substrate for grounding; and
forming a patch, which resonates at a frequency in a reference range, on an upper surface of the composite substrate,
wherein when the composite substrate and the patch are stretched,
a dielectric constant of the composite substrate is varied, and a frequency of the patch is maintained within the reference range.

11. The method of claim 10, wherein in the forming of the ground panel and in the forming of the patch, at least one of the ground panel and the patch is formed of a metal conductor material having elasticity,

the metal conductor material having elasticity includes silver, copper, gold, or aluminum,
the forming of the ground panel includes forming the ground panel by providing the lower surface of the composite substrate with an ink including the metal conductor material having elasticity, and
the forming of the patch includes forming the metal conductor material having elasticity on the upper surface of the composite substrate in a pattern having a predetermined shape.

12. The method of claim 10, wherein the preparing of the composite substrate includes:

dispersing a stretchable polymer having elasticity in a solvent to prepare a source solution;
mixing dielectric powder having dielectric properties with the source solution to prepare a dielectric source;
providing the dielectric powder with a catalyst that causes an attractive force between dielectric powders so as to form a dielectric cluster having a predetermined shape from the dielectric powders; and
curing the dielectric source in which the dielectric cluster is formed to manufacture the composite substrate in which the dielectric cluster is dispersed in a stretchable polymer matrix formed of the stretchable polymer, and
in the forming of the dielectric cluster, the catalyst is provided to the dielectric source by a dripping method, and the catalyst is water.

13. An antenna, wherein the antenna resonates at a frequency in a reference range,

when the antenna is stretched, a dielectric constant is varied by a square of a stretched length, and
the frequency is maintained within the reference range.

14. A flexible system comprising the antenna of claim 13.

【Fig. 1】

【Fig. 2】

```
            ┌─────────┐
            │  Start  │
            └────┬────┘
                 │
                 ▼
┌────────────────────────────────────────────┐
│      Manufacturing composite substrate     │────S100
└────────────────────┬───────────────────────┘
                     │
                     ▼
┌────────────────────────────────────────────┐
│  Forming ground panel on lower surface of  │
│            composite substrate             │────S200
└────────────────────┬───────────────────────┘
                     │
                     ▼
┌────────────────────────────────────────────┐
│ Forming patch on upper surface of composite│────S300
│                  substrate                 │
└────────────────────┬───────────────────────┘
                     │
                     ▼
                ┌─────────┐
                │   End   │
                └─────────┘
```

【Fig. 3】

【Fig. 4】

<u>S100</u>

```
┌─────────────────────────────────────────────────────┐
│  Dissolving stretchable polymer material having       │  ─S110
│  elasticity in solvent to prepare stretchable solution│
└─────────────────────────────────────────────────────┘
                          │
                          ▼
┌─────────────────────────────────────────────────────┐
│  Mixing dielectric powder having dielectric           │  ─S120
│  properties with stretchable solution to prepare      │
│  dielectric source                                    │
└─────────────────────────────────────────────────────┘
                          │
                          ▼
┌─────────────────────────────────────────────────────┐
│  Providing dielectric source with catalyst that       │  ─S130
│  causes attractive force between dielectric powders   │
│  so as to form dielectric cluster from dielectric     │
│  powder                                               │
└─────────────────────────────────────────────────────┘
                          │
                          ▼
┌─────────────────────────────────────────────────────┐
│  Curing dielectric source in which dielectric cluster │  ─S140
│  is formed to manufacture composite substrate having  │
│  dielectric cluster that is dispersed in stretchable  │
│  polymer matrix formed of stretchable polymer         │
└─────────────────────────────────────────────────────┘
```

【Fig. 5】

<u>S110</u>

【Fig. 6】

S120

【Fig. 7】

S130

【Fig. 8】

S130

【Fig. 9】

S140

【Fig. 10】

S200, S300

200 110 100 90

$h_p$ $h_s$ $h_g$

【Fig. 11】

【Fig. 12】

(a)

(b)

(c)

(d)

【Fig. 13】

0 %　　　　　　　　30 %

(a)　　　　　　　　(b)

【Fig. 14】

【Fig. 15】

【Fig. 16】

**Von Mises Stress**

0          30

$BaTiO_3$-µP Composite ($V_f$ = 10%)

(a)

DEEC ($V_f$ = 10%)

(b)

【Fig. 17】

Max Principal Strain
0          100

Initial State
(a)

$v_f = 13\%$

$\varepsilon_{app} = 30\%$    Clusters
can deform
(b)

$v_f = 13\%$

$\varepsilon_{app} = 30\%$    Clusters
cannot deform
(c)

Clusters can deform: $\dfrac{E_d}{E_m} \approx 10^0$

Max Principal Strain
0     100

$\nu_f = 1\%$    $\nu_f = 4\%$    $\nu_f = 7\%$    $\nu_f = 10\%$    $\nu_f = 13\%$

$\varepsilon_{app} = 30\%$

(a)

Clusters cannot deform: $\dfrac{E_d}{E_m} \approx 10^3$

Max Principal Strain
0     100

$\nu_f = 1\%$    $\nu_f = 4\%$    $\nu_f = 7\%$    $\nu_f = 10\%$    $\nu_f = 13\%$

$\varepsilon_{app} = 30\%$

(b)

[Fig. 18]

EP 4 629 441 A1

【Fig. 19】

Max. Principal
Strain (kPa)

$\varepsilon_{app} = 30\%$

(a)

$\varepsilon_{app} = 30\%$

(b)

【Fig. 20】

(a)

$\varepsilon_{app} = 30\%$

(b)

Electric Field(A.U.)

0         1

C=95F

(c)

C=96fF

(d)

C(fF)

Strain(%)

(e)

【Fig. 21】

【Fig. 22】

【Fig. 23】

(a)

(b)

(c)

【Fig. 24】

(a)

(b)

【Fig. 25】

【Fig. 26】

【Fig. 27】

(a)

(b)

【Fig. 28】

(a)

(b)

【Fig. 29】

(a)

(b)

【Fig. 30】

(a)

BaTiO$_3$ Composite (10 Vol%)
DEEC (10 Vol%)
BaTiO$_3$-μP(10 vol%)

(b)

VHB
DEEC-Al$_2$O$_3$
DEEC-BaTiO$_3$
DEEC-SrTiO$_3$
BaTiO$_3$-μP

(c)

1 Vol%
4 Vol%
7 Vol%
10 Vol%
13 Vol%

【Fig. 31】

[Fig. 32]

(a)

(b)

【Fig. 33】

【Fig. 34】

【Fig. 35】

【Fig. 36】

(a)

(b)

Large shift under strain

(c)

【Fig. 37】

【Fig. 38】

【Fig. 39】

(a)                    (b)

【Fig. 40】

(a)

(b)

【Fig. 41】

【Fig. 42】

(a)

(b)

【Fig. 43】

(a)

(b)

【Fig. 44】

(a)

(b)

(c)

【Fig. 45】

(a)

(b)

【Fig. 46】

【Fig. 47】

(a)

(b)

【Fig. 48】

(a)

(b)

(c)

[Fig. 49]

【Fig. 50】

【Fig. 51】

(a)

| Design parameters | $l_1$ | $l_2$ | $l_3$ | $l_4$ | $l_s$ | $l_{sl}$ | $l_4$ | $w_2$ | $w_3$ | $w_4$ | $w_5$ | $w_s$ | $l_p$ | $w_p$ |
|---|---|---|---|---|---|---|---|---|---|---|---|---|---|---|
| Ecoflex | 55.5 | 37 | 5 | 14.5 | - | - | 60 | 30 | 12.5 | 1 | 2.1 | - | - | - |
| Batiox+Ecoflex | 55.5 | 23.5 | 5 | 14.5 | - | - | 60 | 30 | 12.5 | 1 | 2.1 | - | - | - |
| Biatiox+Eco+DI | 55.5 | 25.5 | 5 | 14.5 | - | - | 60 | 30 | 12.5 | 1 | 2.1 | - | - | - |
| New design Ecoflex | 51 | 28.5 | 3.5 | 12 | 3 | 3 | 60 | 30 | 12.5 | 1 | 2.1 | 3 | 1 | 1 |
| New design Batiox | 51 | 17 | 3.5 | 12 | 3 | 1.5 | 60 | 30 | 12.5 | 1 | 2.1 | 3 | 1 | 1 |

(b)

【Fig. 52】

【Fig. 53】

(a)

(b)

【Fig. 54】

(a)

(b)

【Fig. 55】

【Fig. 56】

(a)

(b)

【Fig. 57】

(a)

(b)

【Fig. 58】

(a)

(b)

(c)

【Fig. 59】

【Fig. 60】

(a)

(b)

【Fig. 61】

(a)

(b)　　　　　　　　　　(c)

【Fig. 62】

(a)

(b)

【Fig. 63】

E-plane

M-BaTiO₃ (Detune)

M-BaTiO₃ (Solid)

Ecoflex(Solid)
Ecoflex(Detune)

(a)

H-plane

M-BaTiO₃ (Detune)
M-BaTiO₃ (Solid)

Ecoflex(Solid)

Ecoflex(Detune)

(b)

【Fig. 64】

【Fig. 65】

【Fig. 66】

E(V/m)

3000

0

1 mm
(a)

500 μm
(b)

250 μm
(c)

200 μm
(d)

150 μm
(e)

100 μm
(f)

50 μm
(g)

25 μm
(h)

## INTERNATIONAL SEARCH REPORT

| International application No. |
| --- |
| **PCT/KR2023/019712** |

| | |
| --- | --- |
| **A.** | **CLASSIFICATION OF SUBJECT MATTER** |
| | **H01Q 9/04**(2006.01)i; **H05K 1/02**(2006.01)i; **H05K 1/03**(2006.01)i |
| | According to International Patent Classification (IPC) or to both national classification and IPC |

| | |
| --- | --- |
| **B.** | **FIELDS SEARCHED** |
| Minimum documentation searched (classification system followed by classification symbols) |
| | H01Q 9/04(2006.01); A61B 34/20(2016.01); A61B 90/00(2016.01); C08G 18/64(2006.01); C09D 11/52(2014.01); D03D 15/00(2006.01); H01B 5/00(2006.01); H01Q 1/38(2006.01) |
| Documentation searched other than minimum documentation to the extent that such documents are included in the fields searched |
| | Korean utility models and applications for utility models: IPC as above |
| | Japanese utility models and applications for utility models: IPC as above |
| Electronic data base consulted during the international search (name of data base and, where practicable, search terms used) |
| | eKOMPASS (KIPO internal) & keywords: 안테나(antenna), 플렉서블(flexible), 유전율(dielectric constant), 주파수(frequency), 클러스터(cluster), 고분자(polymer) |

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| | KR 10-2236940 B1 (KOREA INSTITUTE OF INDUSTRIAL TECHNOLOGY) 06 April 2021 (2021-04-06) | |
| Y | See paragraphs [0042]-[0136], claim 1 and figure 1. | 1-12 |
| A | | 13-14 |
| | KR 10-1627090 B1 (SAEMON TECH. CO., LTD.) 03 June 2016 (2016-06-03) | |
| Y | See paragraph [0024] and figure 2. | 1-12 |
| | KR 10-2019-0135732 A (KOREA INSTITUTE OF SCIENCE AND TECHNOLOGY) 09 December 2019 (2019-12-09) | |
| X | See paragraphs [0040]-[0134] and figure 11. | 13-14 |
| Y | | 3-4,9 |

| | |
| --- | --- |
| ✓ Further documents are listed in the continuation of Box C. | ✓ See patent family annex. |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **05 March 2024** | **05 March 2024** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2023/019712** |

### C.    DOCUMENTS CONSIDERED TO BE RELEVANT

| Category* | Citation of document, with indication, where appropriate, of the relevant passages | Relevant to claim No. |
| --- | --- | --- |
| Y | KR 10-2021-0090954 A (KOREA INSTITUTE OF SCIENCE AND TECHNOLOGY et al.) 21 July 2021 (2021-07-21)<br>       See paragraphs [0092]-[0104]. | 8-9,12 |
| A | KR 10-2020-0039303 A (KOREA INSTITUTE OF SCIENCE AND TECHNOLOGY) 16 April 2020 (2020-04-16)<br>       See claims 1 and 9. | 1-14 |

Form PCT/ISA/210 (second sheet) (July 2022)

## INTERNATIONAL SEARCH REPORT

| International application No. |
| --- |
| **PCT/KR2023/019712** |

| **Box No. III** | **Observations where unity of invention is lacking (Continuation of item 3 of first sheet)** |
| --- | --- |

This International Searching Authority found multiple inventions in this international application, as follows:

The invention of group 1: claims 1-12 pertain to an antenna and a manufacturing method therefor, the antenna having a composite substrate of which the, the dielectric constant is changed and a patch of which the frequency is maintained to be within a reference range, if the composite substrate and the patch are stretched

The invention of group 2: claims 13-14 pertain to an antenna and a flexible system comprising same, the antenna resonating in a reference range frequency, and, if contracting, having a dielectric constant that is variable by the square of the stretched length and a frequency that is maintained to be within a reference range.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**   ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

**INTERNATIONAL SEARCH REPORT**
Information on patent family members

International application No.

**PCT/KR2023/019712**

| Patent document cited in search report | Publication date (day/month/year) | Patent family member(s) | Publication date (day/month/year) |
|---|---|---|---|
| KR 10-2236940 B1 | 06 April 2021 | None | |
| KR 10-1627090 B1 | 03 June 2016 | None | |
| KR 10-2019-0135732 A | 09 December 2019 | KR 10-2116281 B1 | 29 May 2020 |
| KR 10-2021-0090954 A | 21 July 2021 | KR 10-2331774 B1 | 30 November 2021 |
| KR 10-2020-0039303 A | 16 April 2020 | KR 10-2102185 B1 | 21 April 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020100011023

- KR 1020170017612